# EUROPEAN PATENT SPECIFICATION

(11) **EP 2 061 077 B1**
(45) Date of publication and mention of the grant of the patent: **11.11.2015**
(21) Application number: 08167274.3
(22) Date of filing: 22.10.2008
(51) Int. Cl.: H01L 23/367, H01L 23/373

(54) **Sheet structure and method of manufacturing the same**
Folienstruktur und Herstellungsverfahren dafür
Structure de feuille et son procédé de fabrication

(30) Priority: 22.10.2007 JP 2007273584; 19.09.2008 JP 2008241413
(43) Date of publication of application: 20.05.2009
(73) Proprietor: Fujitsu Limited, Kawasaki-shi, Kanagawa 211-8588 (JP)
(72) Inventor: Iwai, Taisuke, Kawasaki-shi, Kanagawa 211-8588 (JP); Kondo, Daiyu, Kawasaki-shi Kanagawa 211-8588 (JP); Yamaguchi, Yoshitaka, Kawasaki-shi Kanagawa 211-8588 (JP); Soga, Ikuo, Kawasaki-shi Kanagawa 211-8588 (JP); Hirose, Shinichi, Kawasaki-shi, Kanagawa 211-8588 (JP)
(74) Representative: Fenlon, Christine Lesley

(56) References cited:
- WO-A-2007/111107
- JP-A- 2007 009 213
- US-A1- 2004 265 489
- US-A1- 2005 145 367
- US-A1- 2006 219 689
- US-A1- 2006 234 056
- US-A1- 2007 004 081
- US-A1- 2007 134 599
- US-A1- 2007 155 136
- US-B1- 6 311 769
- US-B1- 6 407 922

## Description

### FIELD

The present invention relates to a sheet structure and a method of manufacturing the same, more specifically, a sheet structure comprising a linear structure of carbon atoms oriented vertical to the sheet surface and its manufacturing method, and an electronic instrument using such a sheet structure.

### BACKGROUND

The electronic parts used in the CPUs (Central Processing Units), etc. of servers, personal computers, etc. are needed to have high radiation efficiency of heat generated by semiconductor elements. For the effective radiation of the heat generated in the semiconductor elements, the structure that a heat spreader made of a material of a high specific thermal conductivity, such as copper or another, is disposed over the semiconductor element with a thermal conductive sheet, such as indium sheet or another, disposed immediately above the semiconductor element interposed therebetween.

However, due to the recent large increase in demand for rare metals, the price of indium has gone up, and substitute materials which are less expensive than indium are desired. In terms of the physical properties, it cannot be said that the specific thermal conductivity of indium (50 W/m·K) is high. To more effectively radiate the heat generated by the semiconductor elements, materials of higher thermal conductivities are desired.

In such background, as a material whose thermal conductivity is higher than indium, the linear structure of carbon atoms, which is typically the carbon nanotube, is noted. The carbon nanotube not only has a very high thermal conductivity (1500 W/m·K) but also is superior in flexibility and heat resistance, and has high potential as a heat radiation material.

US 2009/0016951 A1 discloses a device structure of carbon fibers, organized by a plurality of carbon fibers, including: an aggregate of the carbon fibers aligned in a lengthwise direction, in which a density of the carbon fibers at one side end is different from a density of the carbon fibers at the other side end. The density, at both side ends, of the aggregate of the carbon fibers differs at one side end and the other side end.

US 2007/0004081 A1 discloses a method for manufacturing a thermal interface material having a plurality of carbon nanotubes , wherein the interstices between the carbon nanotubes are filled with a liquid state base material.

US 2006/0219689 A1 discloses a thermal interface material including a macromolecular material matrix and a number of thermally conductive fibers embedded in the macromolecular matrix uniformly. The macromolecular matrix has a first surface and an opposite second surface. The thermally conductive fibers are substantially parallel to each other, and extend from the first surface to the second surface.

As a thermal conductive sheet using carbon nanotubes, a thermal conductive sheet including carbon nanotubes dispersed in a resin, a thermal conductive sheet including carbon nanotube bundles orientationally grown on a substrate, which are buried with a resin, etc. are proposed.

However, in the proposed thermal conductive sheets, the higher thermal conductivity of the carbon nanotube cannot be sufficiently utilized.

### SUMMARY

It is desirable to provide a sheet structure of a very high thermal conductivity and electric conductivity, which uses a linear structure of carbon atoms (according to claim 1) and its manufacturing method (according to claims 6, 8), and an electronic instrument using the sheet structure (according to claim 5).

### BRIEF DESCRIPTION OF DRAWINGS

FIG. 1A is a plan view illustrating a structure of the carbon nanotube sheet according to a first embodiment of the present invention;
FIG. 1B is a diagrammatic sectional view illustrating the structure of the carbon nanotube sheet according to the first embodiment of the present invention;
FIG. 2 is a graph illustrating a relationship between the thermal conductivity of the carbon nanotube sheet according to the first embodiment of the present invention and the gap of the carbon nanotube bundles;
FIG. 3 is a view explaining the gap of the carbon nanotube bundles of the carbon nanotube sheet according to the first embodiment of the present invention;
FIGs. 4A-4E are plan views illustrating configurations of the carbon nanotube bundles of the carbon nanotube sheet according to the first embodiment of the present invention;
FIGs. 5A-5E are diagrammatic sectional views illustrating structures of the carbon nanotube sheet according to the first embodiment of the present invention;
FIGs. 6A-6D and 7A-7D are sectional views illustrating a method of manufacturing the carbon nanotube sheet according to the first embodiment of the present invention;
FIG. 8A is a perspective view illustrating a structure of the carbon nanotube sheet according to a second embodiment of the present invention;
FIG. 8B is a diagrammatic sectional view illustrating the structure of the carbon nanotube sheet according to the second embodiment of the present invention;
FIGs. 9A-9C, 10A-10B and 11A-11B are sectional views illustrating a method of manufacturing the carbon nanotube sheet according to the second embodiment of the present invention;
FIG. 12A is a perspective view illustrating a structure of the carbon nanotube sheet according to a third embodiment of the present invention;
FIG. 12B is a diagrammatic sectional view illustrating the structure of the carbon nanotube sheet according to the third embodiment of the present invention;
FIGs. 13A-13C and 14A-14C are sectional views illustrating a method of manufacturing the carbon nanotube sheet according to the third embodiment of the present invention;
FIG. 15A is a plan view illustrating a structure of the carbon nanotube sheet according to a fourth embodiment of the present invention;
FIG. 15B is a diagrammatic sectional view illustrating the structure of the carbon nanotube sheet according to the fourth embodiment of the present invention;
FIG. 16 is a perspective view illustrating the structure of the carbon nanotube sheet according to the fourth embodiment of the present invention;
FIGs. 17A-17C, 18A-18B and 19A-19B are views illustrating a method of manufacturing the carbon nanotube sheet according to the fourth embodiment of the present invention;
FIG. 20 is a plan view illustrating the structure of the carbon nanotube sheet according to the fourth embodiment of the present invention;
FIG. 21 is a plan view illustrating a structure of the carbon nanotube sheet according to a fifth embodiment of the present invention;
FIGs. 22A-22B are views illustrating a method of manufacturing the carbon nanotube sheet according to the fifth embodiment of the present invention;
FIG. 23 is a diagrammatic sectional view illustrating a structure of the carbon nanotube sheet according to a sixth embodiment of the present invention;
FIG. 24 is a diagrammatic sectional view illustrating a structure of the carbon nanotube sheet according to a seventh embodiment of the present invention;
FIGs. 25A-25D are views illustrating a method of manufacturing the carbon nanotube sheet according to the seventh embodiment of the present invention;
FIG. 26 is a diagrammatic sectional view illustrating a structure of the electronic instrument according to an eighth embodiment of the present invention.
FIG. 27 is a diagrammatic sectional view illustrating a structure of the electronic instrument according to a ninth embodiment of the present invention.
FIG. 28 is a perspective view illustrating a structure of the electronic instrument according to a tenth embodiment of the present invention.

### DESCRIPTION OF THE EMBODIMENTS

### [A First Embodiment]

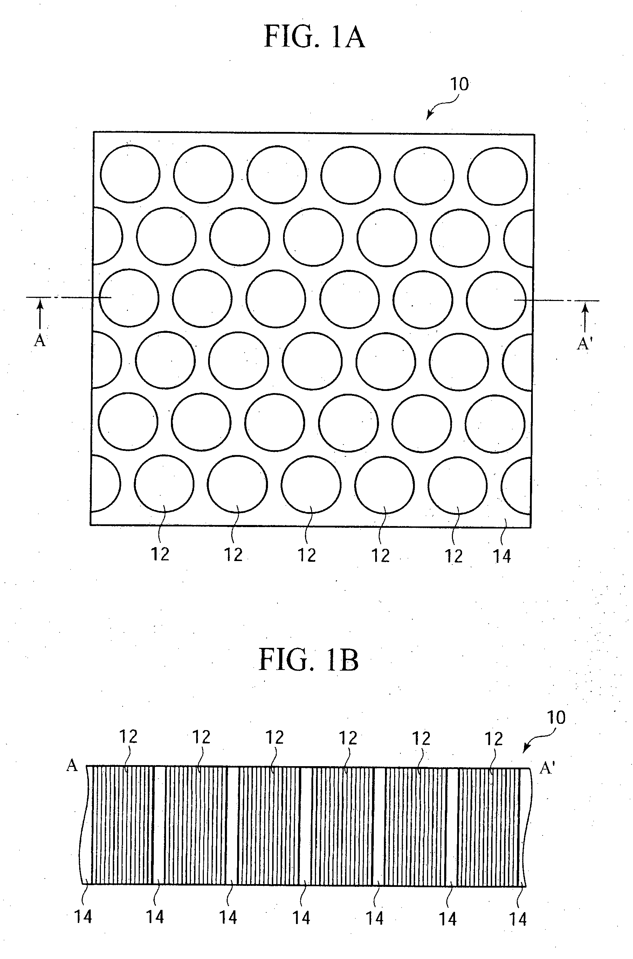

The carbon nanotube sheet and the method of manufacturing the same according to a first embodiment will be explained with reference to FIGs. 1 to 7D.

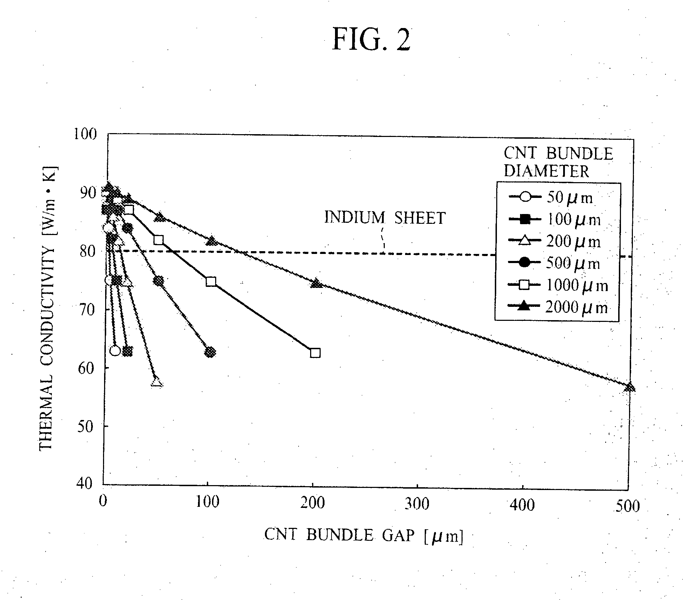

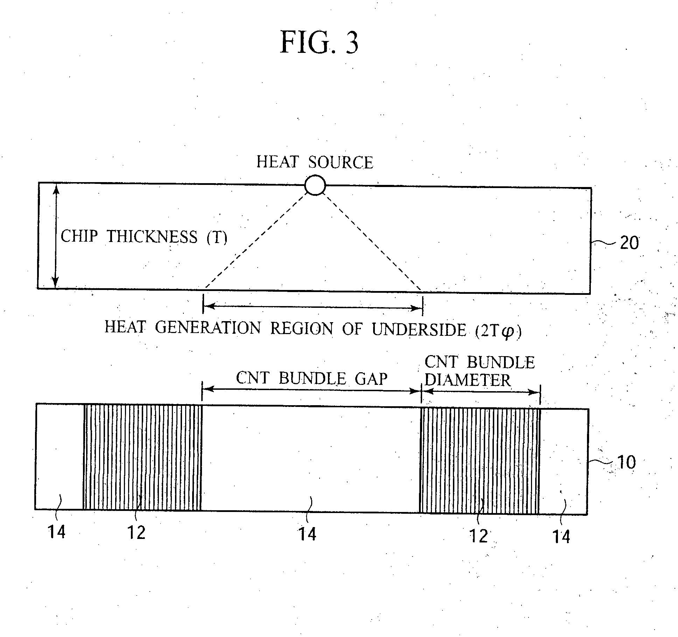

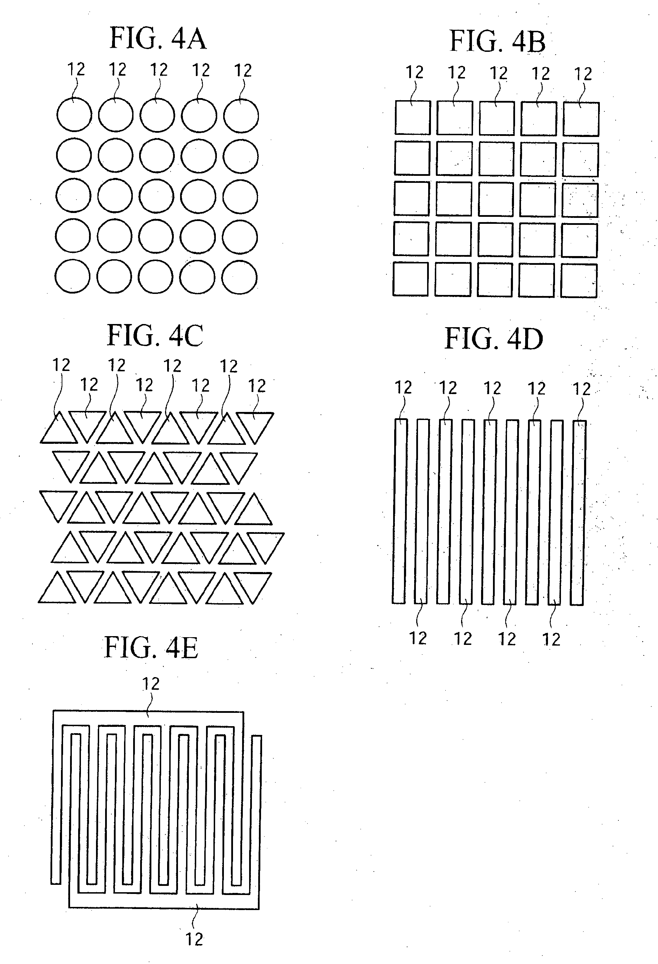

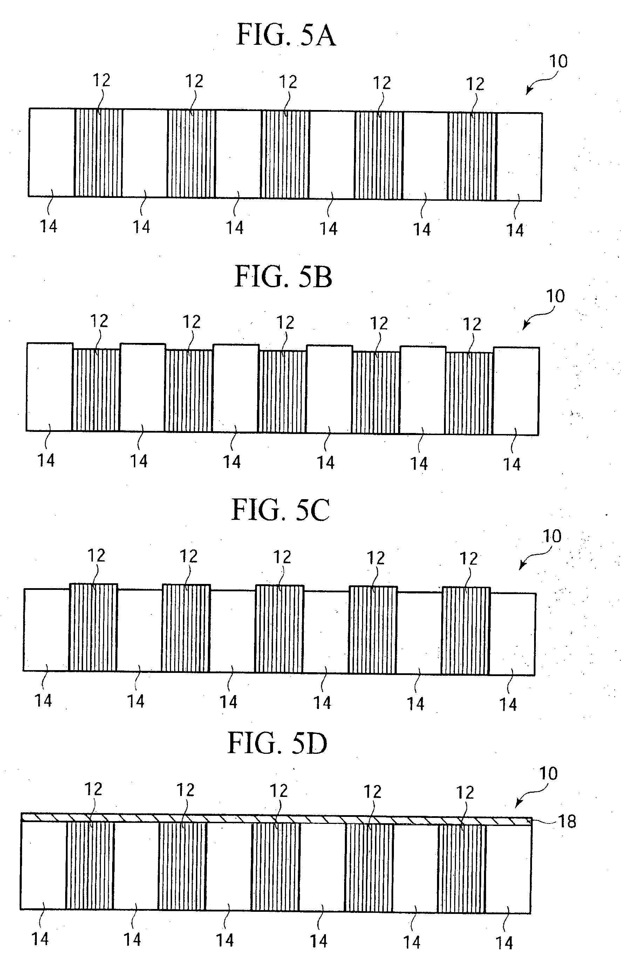

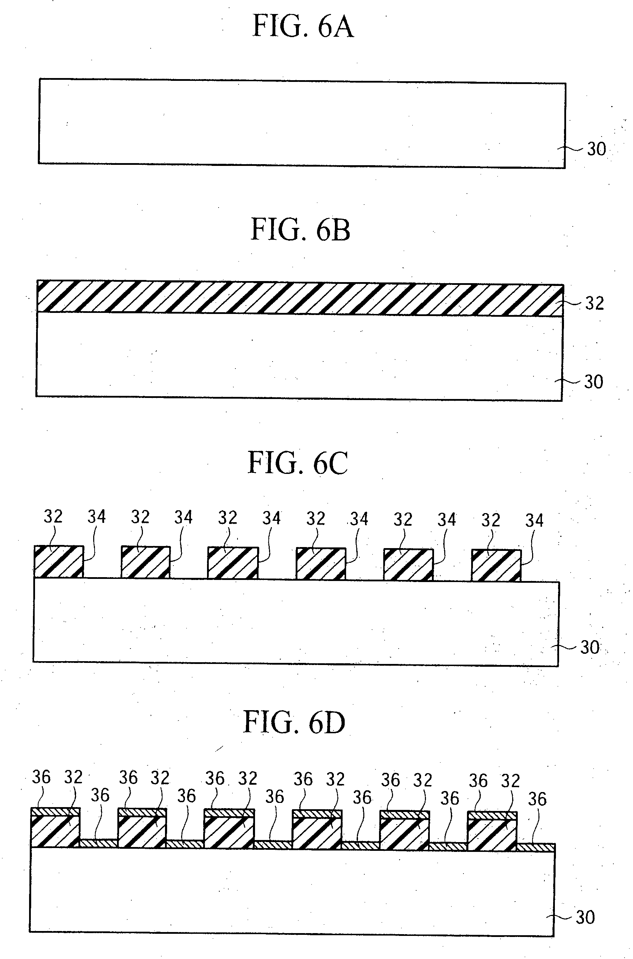

FIGs. 1A and 1B are a plan view and a diagrammatic sectional view illustrating a structure of the carbon nanotube sheet according to the present embodiment. FIG. 2 is a graph illustrating a relationship between the thermal conductivity of the carbon nanotube sheet according to the present embodiment. FIG. 3 is a view explaining the gap of the carbon nanotube bundles of the carbon nanotube sheet according to the present embodiment. FIGs. 4A-4E are plan views illustrating configurations of the carbon nanotube bundles of the carbon nanotube sheet according to the present embodiment. FIGs. 5A-5E are diagrammatic sectional views illustrating the structures of the carbon nanotube sheet according to the present embodiment. FIGs. 6A-7D are sectional views illustrating a method of manufacturing the carbon nanotube sheet according to the present embodiment.

First, the structure of the carbon nanotube sheet according to the present embodiment will be explained with reference to FIGS. 1A and 1B.

As illustrated in FIG. 1A, the carbon nanotube sheet 10 according to the present embodiment has the structure that a plurality of carbon nanotube bundles 12 are arranged at a gap from each other, and the gaps are filled with a filling layer 14 of a resin material or another.

As illustrated in FIG. 1B, each carbon nanotube bundle 12 is formed, extended perpendicularly to the surface of the sheet and contains a plurality of carbon nanotubes oriented vertically to the surface of the sheet. The carbon nanotube can be a single-walled carbon nanotube or a multi-walled carbon nanotube. The density of the carbon nanotubes contained in the carbon nanotube bundle 12 is not especially limited but can be set preferably at not less than about 1×10¹⁰ tubes/cm² from the view point of heat radiation and electric conduction.

The length of the carbon nanotube bundle 12 (the thickness of the sheet) is decided by applications of the carbon nanotube sheet 10. It is not especially limited but can be set preferably at a value of about 5 - 500 µm.

In the carbon nanotube sheet 10 according to the present embodiment, gaps are formed between the carbon nanotube bundles 12, and the filling layer 14 is formed in the gaps. This is for improving the permeability of a filling material to be the filling layer 14, suppressing the configuration changes, such as horizontal falls, etc. to retain the original orientation of the carbon nanotubes (refer to the manufacturing method which will be described later).

The gap required between the carbon nanotube bundles 12 varies depending on the viscosity, etc. of the filling material to be the filling layer 14 and cannot be unconditionally decided. The gap can be set at a width sufficiently larger than a gap between the carbon nanotubes forming each carbon nanotube bundle 12, preferable at a value of about 0.1 - 200 µm. However, as the gap between the carbon nanotube bundles 12 is larger, the surface density of the carbon nanotubes in the sheet surface decreases, i.e., the thermal conductivity of the sheet decreases. The surface density of the carbon nanotubes in the sheet surface varies, also depending on a size of the carbon nanotube bundles 12. Accordingly, the gap between the carbon nanotube bundles 12 can be set suitably for a thermal conductivity required for the sheet in consideration of a size of the carbon nanotube bundles 12.

FIG. 2 is a graph of one of the relationships between the thermal conductivity of the sheet, and the size and the gap of the carbon nanotube bundles 12. FIG. 2 shows the result of the calculation made for carbon nanotube bundles 12 formed in a region of the plane pattern in which the circles are arranged in the close-packed type as illustrated in FIG. 1A with the carbon nanotube density in the carbon nanotube bundle 12 being 1×10¹¹ tubes/cm² and the thermal conductivity of the carbon nanotube per one tube being 1000 W/m·K. The size of the carbon nanotube bundles (CNT bundle) 12 is a diameter of a circles in the region where the carbon nanotube bundle 12 is formed. The gap of the carbon nanotube bundles 12 is a minimum distance between the circles of the region where the carbon nanotube bundles 12 are formed and their adjacent circles. In the graph, the dotted line indicates the thermal conductivity of the conventionally used indium sheet.

As shown in FIG. 2, the thermal conductivity of the carbon nanotube sheet 10 largely depends on the size and the gap of the carbon nanotube bundles 12 and increases as the size of the carbon nanotube bundles 12 is larger and as the gap of the carbon nanotube bundles 12 is smaller.

For the carbon nanotube sheet 10 of FIG. 2, to obtain the carbon nanotube sheet 10 of the thermal conductivity equal to the indium sheet or higher (about 80 W/m·K), it is necessary to set the gap of the CNT bundles at not more than about 4 µm when the diameter of the CNT bundles 12 is 50 µm, at not more than about 7 µm when the diameter of the CNT bundles 12 is 100 µm, at not more than about 14 µm when the diameter of the CNT bundles 12 is 200 µm, at not more than about 36 µm when the diameter of the CNT bundles 12 is 500 µm, at not more than about 72 µm when the diameter of the CNT bundles 12 is 1000 µm, and at not more than about 151 µm when the diameter of the CNT bundles 12 is 2000 µm.

When the semiconductor chip of a CPU or another as the heat generator is considered, during the operation of the semiconductor chip, the whole chip does not generate heat but generates heat at the hot spot (heat generation source) as the center. As illustrated in FIG. 3, when the hot spot is located near the surface of the chip 20, the heat generating region of the chip 10 underside, where heat is generated by the heat spot, is a 2Tφ region when the thickness of the chip 20 is T. For example, the thickness of the chip 20 is 100 µm, the heat generating region of the underside will be about 200 µm. At this time, for the radiation from the underside of the chip 20, it is preferable that the carbon nanotube bundles 12 to be the radiation path is present essentially in the 200 µmφ region. In consideration that it is rare the chip thickness is smaller than 100 µm, preferably, the gap of the carbon nanotube bundles 12 is set at not more than 200 µm.

The plane shape of the respective carbon nanotube bundles 12 is not limited to the circle illustrated in FIG. 1A. The plane shape of the carbon nanotube bundles 12 can be polygons other than circular, e.g., triangle, quadrangle, hexagon, etc.

The layout of a plurality of the carbon nanotube bundles 12 is not limited to the circular close-packed layout as illustrated in FIG. 1A. For example, as illustrated in FIGs. 4A and 4B, the carbon nanotube bundles 12 may be laid out at the respective lattice points of the tetragonal lattice. As illustrated in FIG. 4C, the carbon nanotube bundles 12 of a triangular plane shape may be arranged upside down with respect to the adjacent one in each row. As illustrated in FIG. 4D, the carbon nanotube bundles 12 may be arranged in the stripe pattern. As illustrated in FIG. 4E, the carbon nanotube bundles 12 may be arranged in a comb-pattern.

In the carbon nanotube sheet 16 according to the present embodiment, the carbon nanotube bundles 12 have the upper ends and the lower ends not covered by the filling layer 14, whereby when the carbon nanotube sheet 10 is brought into contact with a heat radiator or a heat generator, the carbon nanotube bundles 12 are in direct contact with the heat radiator or the heat generator, which can largely improve the thermal conductivity.

The carbon nanotube also has electric conductivity, and the carbon nanotube bundles 12 have the upper ends and the lower ends exposed, which makes it possible to use the carbon nanotube bundles 12 also as interconnections passed through the sheet. That is, the carbon nanotube sheet 10 according to the present embodiment can be used not only as a thermal conductive sheet but also as the vertical interconnecting sheet.

The height of the carbon nanotube bundles 12 and the thickness of the filling layer 14 (both are thickness-wise lengths of the sheet) may be the same, as illustrated in FIG. 5A. As illustrated in FIG. 5B, one end of the carbon nanotube bundles 12 may be lower than the surface of the filling layer 14. As illustrated in FIG. 5C, one end of the carbon nanotube bundles 12 may be higher than the surface of the filling layer 14. Such configurations can be respectively formed by varying the material of the filling layer 14 and forming conditions (refer to the manufacturing method described below).

The configuration of FIG. 5B is expected to mitigate stresses exerted to the carbon nanotube bundles 12 by the filling layer 14 when the carbon nanotube sheet 10 is arranged between a heat radiator and a heat generator in press-contact therewith. On the other hand, the configuration of FIG. 5C is expected to improve the close contact of the carbon nanotube bundles 12 to the heat radiator and the heat generator to improve the thermal conductivity. Preferably, the relationship between the height of the carbon nanotube bundles 12 and the thickness of the filling layer 14 is set suitably in accordance with applications of the carbon nanotube sheet 10 and stresses, etc. exerted to the carbon nanotube sheet 10.

As shown in FIG. 5D, a coating film 18 connected to the ends of the carbon nanotube bundles 12 may be provided on at least one surface of the carbon nanotube sheet 10. The coating film 18 is not especially limited as long as the coating film 18 is formed of a material whose thermal conductivity is higher than that of the material forming the filling layer 14. When the carbon nanotube sheet 10 is used for electric conduction, a material having electric conductivity, e.g., a metal, an alloy or others can be used. As the constituent material of the coating film 18, copper (Cu), nickel (Ni), gold (Au) or others, can be used. The coating film 18 may not have essentially a single layer structure and may have a two-layer structure, or a three- or more-layer structure, e.g., the layer structure of titanium (Ti) and gold (Au).

The film thickness of the coating film 18 is not especially limited. Preferably, the film thickness of the coating film is suitably decided, depending on characteristics required of the carbon nanotube sheet 10 and a constituent material of the coating film 18.

The coating film 18 of high thermal conductivity is provided, whereby the contact area of the carbon nanotube sheet 10 with respect to a mounted body (a heat radiator or a heat generator) can be increased with respect to the carbon nanotube sheet 10 without the coating film 18. Thus, the thermal contact resistance between the carbon nanotube bundles 12 and the mounted body is decreased, and the thermal conductivity of the carbon nanotube sheet 10 can be increased. In using the carbon nanotube sheet 10 as a conductive sheet, the electric conductivity can be increased.

In the carbon nanotube sheet 10 illustrated in FIG. 5D, the coating film 18 is formed on one surface of the carbon nanotube sheet 10 illustrated in FIG. 5A, but the coating film 18 may be formed on both surfaces of the carbon nanotube sheet 10. The coating film 18 may be formed on one surface or both surfaces of the carbon nanotube sheet 10 illustrated in FIG. 5B or FIG. 5C.

The constituent material of the filling layer 14 is not especially limited as long as the material has the property that the material is liquid when filling the spaces between the carbon nanotubes and can be hardened later. To give examples, as the organic filling materials, acryl resin, epoxy resin, silicone resin, polyimide resin, etc. can be used. As the inorganic filling materials, insulating film forming compositions by using spin coating, such as SOG (Spin On Glass), etc., can be used. Metal materials, such as indium, solder, metal pastes (e.g., silver paste), etc., can be also used. Conductive polymers, such as polyaniline, polythiophene, etc., can be used.

To the filling layer 14, an additive may be mixed as required. As the additive, a highly thermally conductive material or a highly electrically conductive material, for example, is considered. A highly thermally conductive additive is mixed in the filling layer 14, whereby the thermal conductivity of a part of the filling layer 14 can be improved, and the thermal conductivity of the carbon nanotube sheet as a whole can be improved. When the carbon nanotube sheet 10 is used as an electrically conductive sheet, a highly electrically conductive additive is mixed in the filer layer 14, whereby the electrical conductivity of a part of the filling layer 14 can be improved, and the electric conductivity of the carbon nanotube sheet 10 as a whole can be improved. This is especially effective when a low thermally conductive insulating material, such as an organic filling material or another, for example, is used as the filling layer 14. As the highly thermally conductive material, carbon nanotube, a metal material, aluminum nitride, silica, alumina, graphite, fullerene or others can be used. As the highly electrically conductive material, carbon nanotube, a metal material, etc. can be used.

When the filling layer 14 is formed of a reflowable material, in addition to the effects of improving the thermal conductivity and/or the electrical conductivity of the carbon nanotube sheet 10, the coating film 18 also exhibits an effect for suppressing the carbon nanotubes of the carbon nanotube bundles 12 to loose.

Next, the method of manufacturing the carbon nanotube sheet according to the present embodiment will be explained with reference to FIGs. 6A to 7D.

First, a substrate 30 to be used as the base for forming the carbon nanotube sheet 10 is prepared (FIG. 6A). As the substrate 30, a semiconductor substrate, such as a silicon substrate or another, an alumina (sapphire) substrate, an MgO substrate, a glass substrate or another can be used. Such substrates may have thin film formed on. For example, a silicon substrate with an about 300 nm-thickness silicon oxide film formed on can be used.

The substrate 30 is to be peeled after the carbon nanotube sheet 10 has been formed. For this use of the substrate 30, it is preferable that the substrate 30 has at least the surface to contact the carbon nanotube sheet 10 is formed of a material which is easily peelable from the carbon nanotube sheet 10 or a material which can be selectively etched with respect to the carbon nanotube sheet 10.

Specifically, when acryl resin is used as the material of the filling layer 14, a material which is less adhesive to acryl resin, e.g., silicon oxide film, silicon nitride film or another is formed, whereby the carbon nanotube sheet 10 can be easily peeled. Otherwise, the surface of the substrate 30 is formed of a material, such as silicon oxide film, silicon nitride film or another, which can be selectively etched with respect to the carbon nanotube sheet 10, whereby the film is etched off, and the carbon nanotube sheet 10 can be released from the substrate 30.

Then, on the substrate 30, a photoresist film 32 is formed by spin coating method (FIG. 6B).

Then, in the photoresist film 32, openings 34 exposing the regions for the carbon nanotube bundles 12 to be formed in are formed by photolithography (FIG. 6C). The pattern of the openings 34 is the pattern of, e.g., FIG. 1A. The diameter of the openings 34 (the diameter of the region for the carbon nanotube bundles 12 to be formed in) is, e.g., 100 µm, and the gap between the openings 34 (the gap between the carbon nanotube bundles 12) is, e.g., 20 µm. The pattern of the openings formed in the photoresist film 32 can be various patterns illustrated in, e.g., FIGs. 4A to 4E other than the pattern of FIG. 1A.

Then, a 2.5 nm-thickness Fe (iron) film, for example, is formed by, e.g., sputtering method to form a catalytic metal film 36 of Fe (FIG. 6D). The catalytic metal film 36 is formed on the photoresist film 32 and on the substrate 30 in the openings 34.

As the catalytic metal, Co (cobalt), Ni (nickel), Au (gold), Ag (silver), Pt (platinum) or an alloy containing at least one of them can be used other than Fe. As the catalyst, metal particles formed with a size controlled in advance with a DMA (Differential Mobility Analyzer) or others can be used other than the metal film. In this case as well, the metal species can be the same as that of the thin film.

As the base film of such catalytic metal, a film of Mo (molybdenum), Ti (titanium), Hf (hafnium), Zr (zirconium), Nb (niobium), V (vanadium), TaN (tantalum nitride), TiSiₓ (titanium silicide), Al (aluminum), Al₂O₃ (aluminum oxide), TiOₓ (titanium oxide), Ta (tantalum), W (tungsten), Cu (copper), Au (gold), Pt (platinum), Pd (palladium), TiN (titanium nitride) or an alloy containing at least one of them may be formed. For example, the layer structure of Fe (2.5 nm)/Al (10 nm), the layer structure of Co (2.6 nm)/TiN (5 nm), etc. can be used. When the metal particles are used, the layer structure of, e.g., Co (average diameter: 3.8 nm)/TiN (5 nm) can be used.

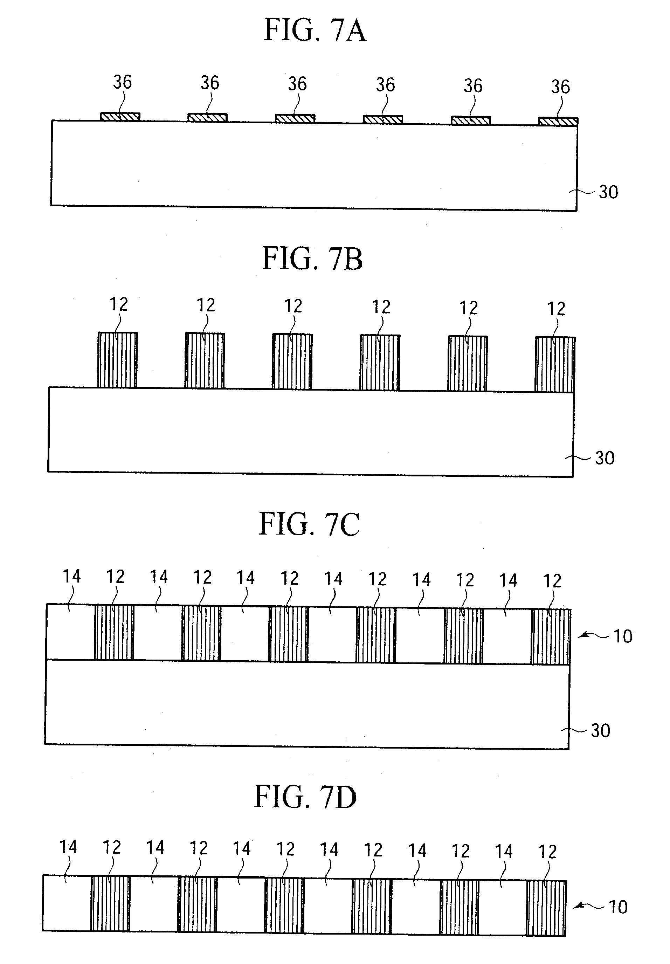

Then, the catalytic metal film 36 on the photoresist film 32 is removed by lift-off together with the photoresist film 32 to leave the catalytic metal film 36 selectively on the substrate 30 in the regions for the carbon nanotube bundles 12 to be formed on (FIG. 7A).

In the above, by the lift-off using photolithography, the catalytic metal film 36 is left selectively in the regions for the carbon nanotube bundles 12 to be formed on, but the process for selectively forming the catalytic metal film 36 is not limited to the above. For example, a metal mask having openings in the regions for the carbon nanotube bundles 12 to be formed in may be used. With the surface of the substrate 30 covered by the metal mask, the catalytic metal is sputtered to thereby form the catalytic metal film 36 selectively in the regions for the carbon nanotube bundles 12 to be formed on.

Then, over the substrate 30, carbon nanotubes are grown with the catalytic metal film 36 as the catalyst by, e.g., hot filament CVD method. The conditions for growing the carbon nanotubes are, e.g., the raw material gas: the mixed gas of acetylene and argon (partial pressure ratio 1:9), the total gas pressure in the film forming chamber: 1 kPa, the hot filament temperature: 1000 °C, and the growing period of time: 20 minutes. Thus, multi-walled carbon nanotubes of 3 - 6 walls (average: about 4 walls), a 4 - 8 nm-diameter (average: about 6 nm) and an 80 µm-length (growth rate: 4 µm/min) can be grown. The carbon nanotubes may be grown another film forming process, such as thermal CVD method, remote plasma CVD method or others. The grown carbon nanotubes may be single-walled carbon nanotubes. As the carbon raw material, other than acetylene, hydrocarbons, such as methane, ethylene, etc., and alcohols, such as ethanol, methanol, etc., and others may be used.

Thus, carbon nanotube bundles 12 containing a plurality of carbon nanotubes oriented in the normal direction of the substrate 30 (vertically) are selectively formed on the regions of the substrate 30, where the catalytic metal film 36 is formed (FIG. 7B). In the carbon nanotube bundles 12 formed under the above-described growing conditions, the carbon nanotube density inside the carbon nanotube bundles 12 is about 1×10¹¹ tubes/cm².

Next, a filling material to be the filling layer 14 is applied by, e.g., spin coating method. At this time, the viscosity of the coating solution and the rotation number of the spin coater are suitably set so that the filling material does not cover the tops of the carbon nanotube bundles 12.

For example, when acryl resin is used as the filling material, to make the height of the carbon nanotube bundles 12 and the thickness of the filling layer 14 substantially equal to each other (see FIG. 5A), it can be realized by, e.g., applying acrylic resin of a 440 mPa·s viscosity under the conditions of 2000 rpm and 20 seconds.

When the thickness of the filling layer 14 is made smaller than the height of the carbon nanotube bundles 12 (see FIG. 5C), it can be realized, e.g., by applying acryl resin of a 440 mPa·s viscosity under the conditions of 4000 rpm and 20 seconds. Otherwise, it can be realized by, e.g., applying acryl resin diluted to 80 wt% with an MEK (methyl ethyl ketone) solution under the conditions of 2000 rpm and 20 seconds.

The upper surfaces of the carbon nanotubes bundles 12 may be exposed by ashing method or others after the filling material has been formed, covering the tops of the carbon nanotube bundles 12 (refer to a second embodiment).

The filling material is not especially limited as long as the filling material is liquid and then hardenable. Specifically, as the organic filling materials, acryl resin, epoxy resin, silicone resin, polyimide resin, etc. can be used. As the inorganic filling materials, insulating film forming compositions by using spin coating, such as SOG (Spin On Glass), etc., can be used. Metal materials, such as indium, solder, metal pastes (e.g., silver paste), etc., can be also used. Conductive polymers, such as polyaniline, polythiophene, etc., can be also used.

In forming the filling layer 14, because of a plurality of the carbon nanotube bundles 12 formed on the substrate 30 with gaps therebetween, the applied filling material first spread on the substrate 30 along the gaps. Then, the filling material goes on permeating into the carbon nanotube bundles 12.

If the carbon nanotubes are formed on the entire surface of the substrate 30, when the filling material permeates into the carbon nanotube, the discrete carbon nanotubes coagulate with each other, and the carbon nanotubes lose the orientation they have originally retained and tend to have configuration changes, e.g., to fall horizontally.

However, as in the present embodiment, providing a gap between the carbon nanotube bundles 12 allows the filling material to spread allover the surface of the substrate 30 and then permeate into the carbon nanotube bundles 12. Accordingly, the filling material filled in advance between the carbon nanotube bundles 12 acts as the supporter for retaining the configuration of the carbon nanotubes when the filling material permeates into the carbon nanotube bundles 12 and prevents the configuration changes of the carbon nanotube bundles 12. Thus, the filling layer 14 can be formed with the orientation of the carbon nanotube bundles 12 retained.

A gap required between the carbon nanotube bundles 12 varies, depending on a kind, viscosity, etc. of the filling material and cannot be unconditionally decided. The inventors of the present invention made studies and confirmed that a gap of not less than 0.1 µm can prevent the configuration change of the carbon nanotube bundles 12.

The resin layer 14 may be formed by immersing the substrate 30 in a solution of the filling material (the so-called dip method). In this case as well, the gap provided between the carbon nanotube bundles 12 can prevent the configuration change of the carbon nanotube bundles 12.

Next, the filling material is hardened to form the filling layer 14 of the filling material (FIG. 7C). For example, when a photo-curable material, such as acryl resin or others, is used as the filling material, the filler can be hardened by light irradiation. When a thermosetting material, such as epoxy resin, silicone resin or others, is used as the filling material, the filling material can be hardened by thermal processing. Epoxy resin can be thermoset, e.g., by 1 hour of heat processing of 150 °C. Silicone resin can be thermoset, e.g., by 1 hour of heat processing of 200 °C.

After the filling layer 14 has been hardened, when the upper ends of the carbon nanotube bundles 12 are not sufficiently exposed or are covered by the filling layer 14, the filling layer 14 on the carbon nanotube bundles 12 may be removed by CMP (Chemical Mechanical Polishing) or oxygen plasma ashing.

Next, the carbon nanotube bundles 12 and the filling layer 14 are peeled from the substrate 20, and the carbon nanotube sheet 10 is obtained (FIG. 7D).

At this time, with the surface of the substrate 30 being formed of a material which is able to easily peel the carbon nanotube sheet 10, when the silicon oxide film or silicon nitride film, for example, is formed on the surface of the substrate 30, and the filling layer 14 is formed of acryl resin, the carbon nanotube sheet 10 can be easily peeled from the substrate 30.

Otherwise, with a layer which cannot easily peel the carbon nanotube sheet 10 but can be etched selectively with respect to the carbon nanotube sheet 10, when silicon oxide film or silicon nitride film is formed on the surface of the substrate 10, and the filling layer 14 is formed of acryl resin, for example, the carbon nanotube sheet 10 can be easily peeled form the substrate 30. The carbon nanotube sheet 10 can be peeled from the substrate 30 by removing the silicon oxide film or the silicon nitride film by wet etching using, e.g., diluted hydrofluoric acid, boiled phosphoric acid or others.

With the surface of the substrate 30 being formed of a material which can neither easily peel the carbon nanotube sheet 10 nor is selectively removed, when the substrate 30 is a sapphire substrate, and the filling layer 14 is formed of silicone-based resin, for example, a sharp cutting tool is inserted into between the substrate 30 and the carbon nanotube sheet 10 to thereby peel the carbon nanotube sheet 10 from the substrate 30.

Before peeled, the carbon nanotube bundles 12 have been in direct contact with the substrate, so that the carbon nanotube bundles 12 are exposed on the peeled surface thereof on the side of the substrate 30. Accordingly, the carbon nanotube sheet 10 manufactured by the above-described manufacturing method can have both ends of the carbon nanotube bundles 12 exposed on both surfaces of the sheet.

When the filling material is acryl resin, in the process of the acryl resin being hardened, regions where the carbon nanotube bundles 12 are formed are relatively recessed due to the volume contraction ratio difference between the filling material and the carbon nanotubes. That is, the ends of the carbon nanotube bundles 12 on the surface of the carbon nanotube sheet 10 which has been in contact with the substrate 30 are recessed from the surface of the filling layer 14 (see FIG. 5B). These recesses can be utilized to mitigate stresses due to thermal expansion and can play the role of supporting the adhesion.

Then, as required, a coating film 18 is formed on one surface or both surfaces of the carbon nanotube sheet 10 (see FIG. 5D). The coating film 18 can be formed by, e.g., sputtering method. The coating film 18 of the layer film of, e.g., a 10 nm-thickness titanium (Ti) film and, e.g., a 50 nm-thickness gold (Au) film can be used.

As described above, according to the present embodiment, a plurality of the carbon nanotube bundles are formed on the substrate, spaced from each other, and then the filling material is filled to form the filling layer which supports the carbon nanotube bundles, whereby the configuration change of the carbon nanotube bundles in forming the filling layer can be prevented. Thus, the carbon nanotube sheet including the carbon nanotube bundles oriented in the direction of thickness of the sheet can be easily formed. The carbon nanotube bundles can have both ends exposed in the filling layer, which can improve the thermal conductivity and the electric conductivity with respect to an object for the carbon nanotube sheet to be mounted on.

### [A Second Embodiment]

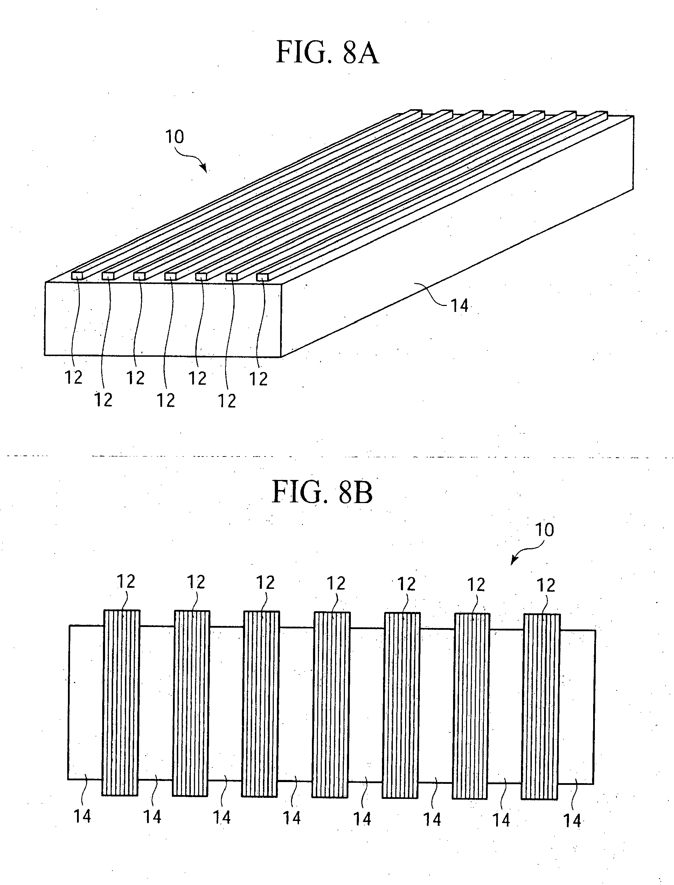

The carbon nanotube sheet and the method of manufacturing the same according to a second embodiment will be explained with reference to FIGs. 8A to 11B. The same members of the present embodiment as the carbon nanotube sheet and the method of manufacturing the same according to the first embodiment illustrated in FIGs. 1A to 7D are represented by the same reference numbers not to repeat or to simplify their explanation.

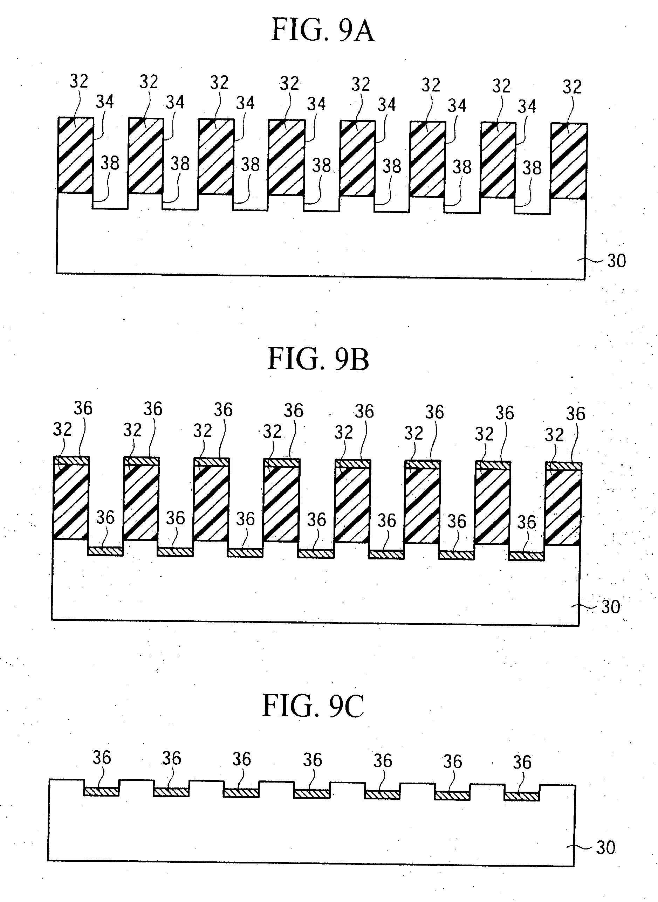

FIG. 8A is a perspective view illustrating a structure of the carbon nanotube sheet according to the present embodiment. FIG. 8B is a diagrammatic sectional view illustrating the structure of the carbon nanotube sheet according to the present embodiment. FIGs. 9A-11B are sectional views illustrating a method of manufacturing the carbon nanotube sheet according to the present embodiment.

First, the structure of the carbon nanotube sheet according to the present embodiment will be explained with reference to FIGs. 8A and 8B.

As illustrated in FIG. 8A, the carbon nanotube sheet 10 according to the present embodiment comprises carbon nanotube bundles 12 of a stripe-shaped pattern buried by a filling layer 14. As illustrated in FIG. 8B, the ends of the carbon nanotube bundles 12 are positioned higher than the surface of the filling layer 14 on both surfaces of the sheet.

Such structure of the carbon nanotube sheet 10 permits the carbon nanotube bundles 12 to be easily and surely connected a heat radiator or a heat generator when the carbon nanotube sheet 10 is brought into contact with the heat radiator or the heat generator, whereby the thermal conductive efficiency can be largely improved. When the carbon nanotube sheet 10 is used as a conductive sheet, the carbon nanotube sheet 10 can be easily and surely connected to other interconnection structures, whereby the contact resistance can be largely reduced.

In the surface of another structure for the carbon nanotube sheet 10 according to the present embodiment to be contacted, surface concaves and convexes which are to engage with the surface convexes and concaves of the carbon nanotube sheet 10 are formed, whereby the concaves and convexes of both are engaged with each other, and the connection with high close contact can be obtained. The stripe-shaped convex and concave pattern of the carbon nanotube sheet 10 according to the present embodiment will be a pattern suitable for such use.

The projection amount of the carbon nanotube bundles 12 with respect to the filling layer 14 is sufficiently not more than about 1 µm (e.g., about 500 nm) from the viewpoint of ensuring the connection to another structure. The manufacturing method according to the present embodiment, which will be described later, can easily control the projection amount of the carbon nanotube bundles 12.

In the example illustrated in FIGs. 8A and 8B, the carbon nanotube bundles 12 have the ends projected with respect to the filling layer 14 on both sides of the sheet but may have the ends projected on only one side of the sheet. The plane pattern of the carbon nanotube bundles 12, the constituent material of the filling layer 14, the conditions for forming the carbon nanotube bundles 12 and the filling layer 14, the film thickness and other property value, etc. which are applicable to the carbon nanotube sheet 10 according to the present embodiment are the same as in carbon nanotube sheet according to the first embodiment.

Next, the method of manufacturing the carbon nanotube sheet according to the present embodiment will be explained with reference to FIGs. 9A to 11B. The detailed conditions for manufacturing the carbon nanotube sheet according to the present embodiment are the same as in the first embodiment.

First, a substrate 30 to be used as the base for manufacturing the carbon nanotube sheet 10 is prepared. As the substrate 30, a silicon substrate with, e.g., an about 1 µm-thickness silicon oxide film formed on is used.

Next, over the substrate 30, by photolithography, a photoresist film 30 having openings 34 for exposing the regions for the carbon nanotube bundles 12 to be formed in is formed.

Next, with the photoresist film 32 as the mask, the substrate 30 is anisotropically etched to form concaves 38 of an about 500 nm-depth in the surface of the substrate 30 (FIG. 9A). The concaves 38 are formed in the regions of the substrate 30, where the carbon nanotube bundles 12 are to be formed. The width of the concaves 38 can be, set at, e.g., 100 µm, and the gap between the concaves 38 can be set at, e.g., 20 µm. Preferably, the width and the gap of the concaves 38 are set suitably in accordance with a thermal conductivity, etc. necessary for the carbon nanotube sheet 10.

The depth of the concaves 38 corresponds to the projection amount of the carbon nanotube sheet 12 with respect to the filling layer 14. Accordingly, the depth of the concaves 38 is suitably set, whereby the projection amount of the carbon nanotube bundles 12 with respect to the filling layer 14 can be controlled.

Then, by, e.g., sputtering method, a 2.5 nm-thickness Fe (iron) film, for example, is formed to form a catalytic metal film 36 of Fe (FIG. 9B). The catalytic metal film 36 is formed on the photoresist film 32 and in the concaves 38 of the substrate 30.

Then, the catalytic metal film 36 on the photoresist film 32 is lifted off together with the photoresist film 32 to leave the catalytic metal film 36 selectively in the concaves 38 of the substrate 30 (FIG. 9C).

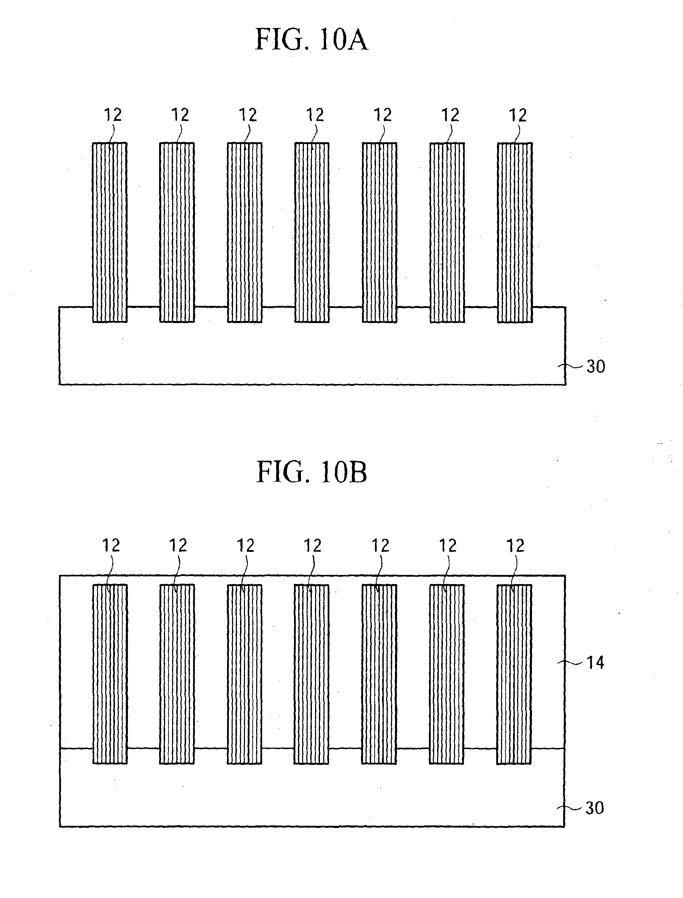

Next, over the substrate 30, with the catalytic metal film 35 as the catalyst, carbon nanotubes are grown by, e.g., hot filament CVD method. Thus, the carbon nanotube bundles 12 containing a plurality of carbon nanotubes oriented in the direction of the normal of the substrate 30 are selectively grown in the region of the concaves 38 (FIG. 10A).

Then, epoxy resin, for example, is applied by, e.g., spin coating method, and then thermal processing of, e.g., 150 °C is made for 1 hour to cure the epoxy resin. Thus, the filling layer of epoxy resin is formed (FIG. 10B).

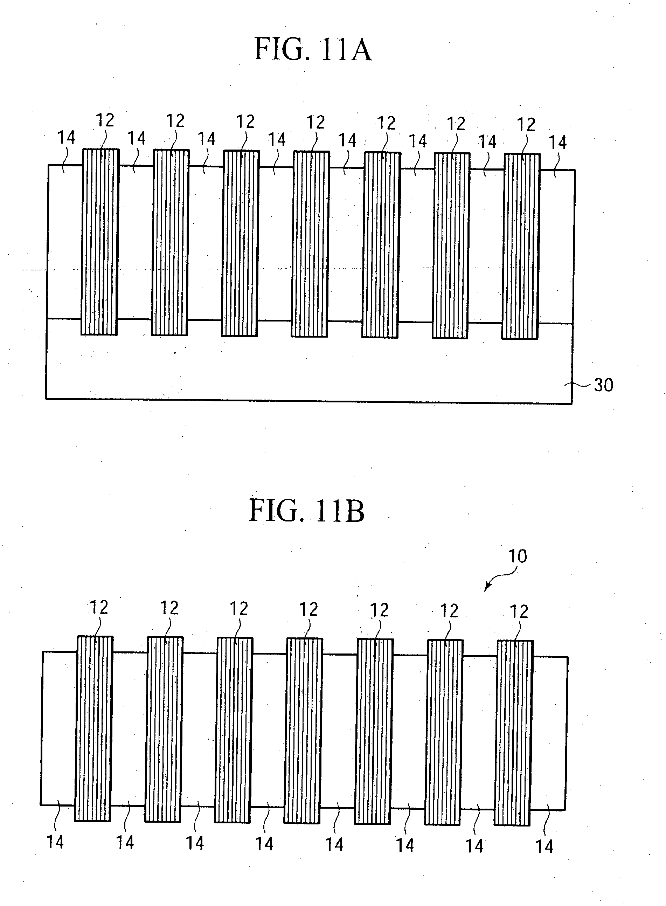

Next, an upper part of the filling layer 14 is removed by, e.g., ashing using oxygen plasma to expose upper ends of the carbon nanotube bundles 12 (FIG. 11A). The conditions for the ashing can be, e.g., the power: 200 W and the period of time: 10 minutes. The upper part of the filling layer 14 may be removed by heating in an oxygen atmosphere in place of the ashing with oxygen plasma.

When epoxy is used as the filling layer 14, the ashing selective ratio of the filling layer 14 to the carbon nanotube bundles 12 is about 1.26. Accordingly, the upper part of the filling layer 14 is ashed, whereby the upper ends of the carbon nanotube bundles 12 can be higher than the surface of the filling layer 14. The etching rate of the filling layer 14 is suitably set, whereby the projection amount of the carbon nanotube bundles 12 with respect to the filling layer 14 can be controlled.

Before the ashing using oxygen plasma, the upper ends of the carbon nanotube bundles 12 may be exposed by, e.g., chemical mechanical polishing.

In the present embodiment, the filling layer 14 is formed, covering the upper ends of the carbon nanotube bundles 12, but as in the first embodiment, the upper ends of the carbon nanotube bundles 12 may be exposed by controlling the application conditions of the filling layer 14. In this case, the step of FIG. 11A is not required. It is sufficient that the upper ends of the carbon nanotube bundles 12 are exposed in the step of FIG. 11A, When the upper ends of the carbon nanotube bundles 12 of only one surface of the sheet is projected.

Then, the carbon nanotube bundles 12 and the resin layer 14 are peeled from the substrate 30, and the carbon nanotube sheet 10 having the carbon nanotube bundles 12 projected with respect to the surface of the filling layer 12 on both surfaces of the sheet is formed (FIG. 11B).

As described above, according to the present embodiment, the carbon nanotube sheet having the ends of the carbon nanotube bundles projected with respect to the surface of the filling layer can be easily manufactured. Such carbon nanotube sheet can further improve the thermal conductivity and the electric conductivity with respect to an object to be mounted on.

### [A Third Embodiment]

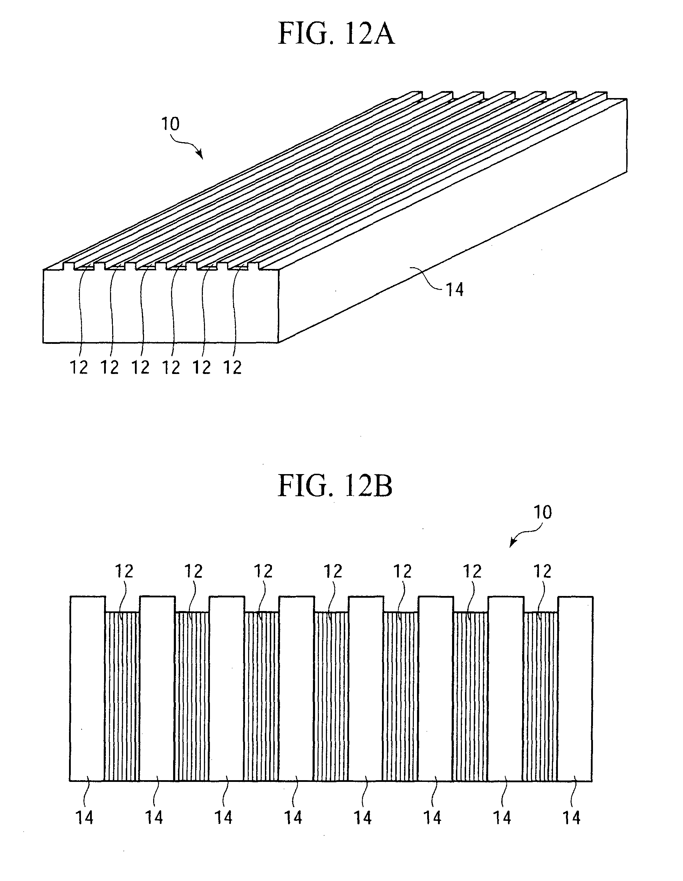

The carbon nanotube sheet and the method of manufacturing the same according to a third embodiment will be explained with reference to FIGs. 12A to 14C. The same members of the present embodiment as those of the carbon nanotube sheet and the method of manufacturing the same according to the first and the second embodiments illustrated in FIGs. 1A to 11B are represented by the same reference numbers not to repeat or to simplify their explanation.

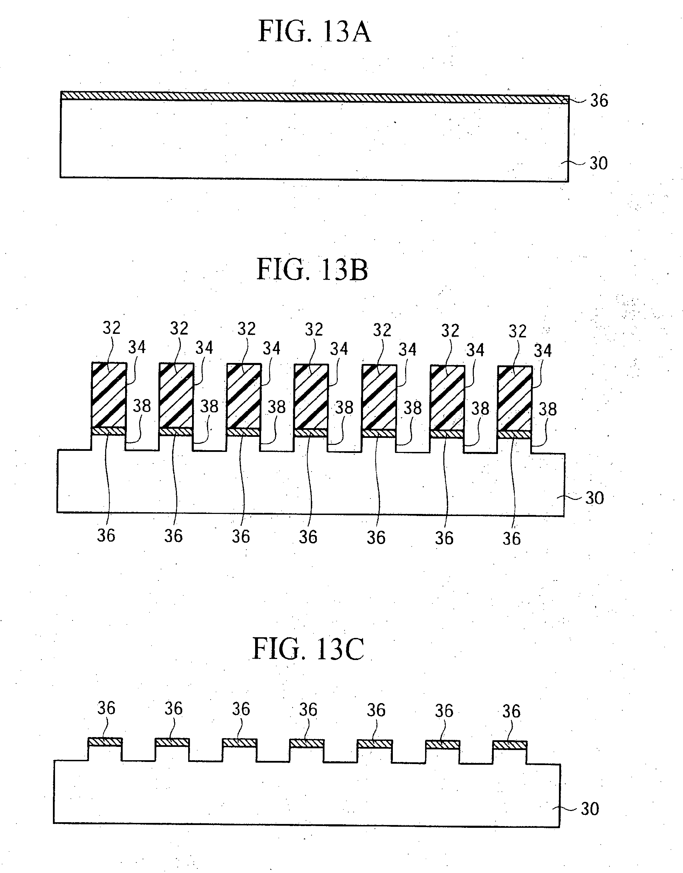

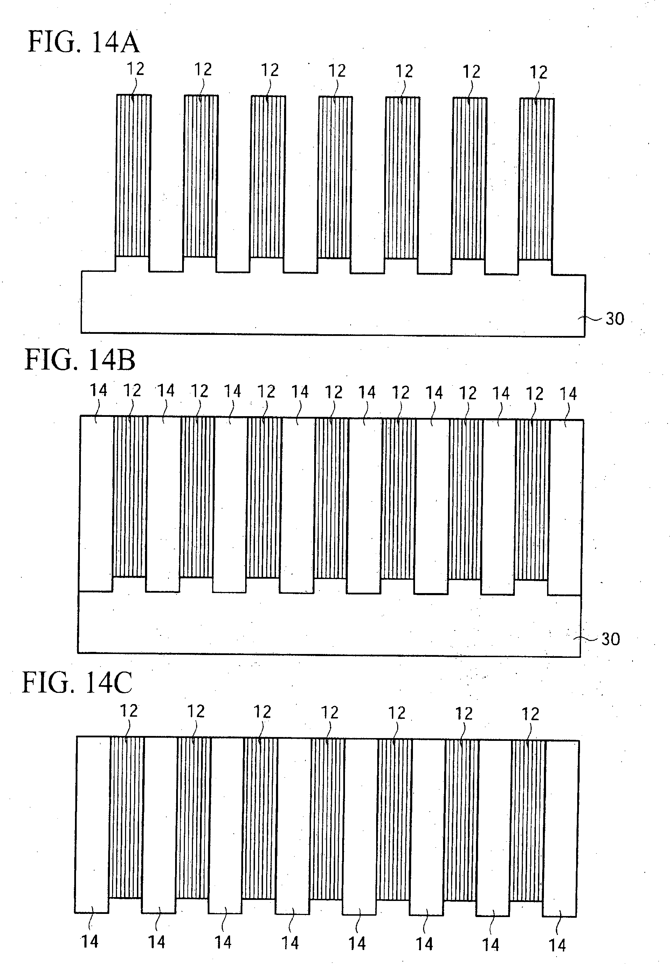

FIG. 12A is a perspective view illustrating a structure of the carbon nanotube sheet according to the present embodiment. FIG. 12B is a diagrammatic sectional view illustrating the structure of the carbon nanotube sheet according to the present embodiment. FIGs. 13A-13C and 14A-14C are sectional views illustrating a method of manufacturing the carbon nanotube sheet according to the present embodiment.

First, the structure of the carbon nanotube sheet according to the present embodiment will be explained with reference to FIGs. 12A and 12B.

As illustrated in FIG. 12A, the carbon nanotube sheet 10 according to the present embodiment comprises carbon nanotube bundles 12 of a stripe-shaped pattern buried by a filling layer 14. As illustrated in FIG. 12B, the ends of the carbon nanotube sheet 12 are lower than the surface of the filling layer 14 on one surface of the sheet. The ends of the carbon nanotube bundles 12 are not covered by the filling layer 14.

Such structure of the carbon nanotube sheet 10 permits the carbon nanotube sheet 10 to be connected directly to a heat radiator or a heat generator when the carbon nanotube sheet 10 is brought into contact with the heat radiator or the heat generator, whereby the thermal conductive efficiency can be largely improved. When the carbon nanotube sheet 10 is used as a conductive sheet, the carbon nanotube sheet 10 can be connected directly to other interconnection structures, and the contact resistance can be largely decreased. As described in the first embodiment, the carbon nanotube sheet 10 is disposed between the heat radiator and the heat generator in close contact, stresses to be exerted to the carbon nanotube bundles 12 could be mitigated by the filling layer 14.

Surface concaves and convexes which are to be engaged with the surface concaves and convexes of the carbon nanotube sheet 10 are formed in the surface of another structure to be contacted with the carbon nanotube sheet 10 according to the present embodiment, whereby the concaves and the convexes are engaged with each other in close contact. The stripe-shaped concave and convex pattern of the carbon nanotube sheet 10 according to the present embodiment will be a suitable pattern for such use.

The plane pattern of the carbon nanotube bundles 12, the constituent material of the filling layer 14, the conditions for forming the carbon nanotube bundles 12 and the filling layer 14, the film thickness and other property values, etc. which are applicable to the carbon nanotube sheet 10 according to the present embodiment are the same as those of the carbon nanotube sheet according to the first embodiment.

Then, the method of manufacturing the carbon nanotube sheet according to the present embodiment will be explained with reference to FIGs. 13A and 14C. The detailed conditions for manufacturing the carbon nanotube sheet 10 according to the present embodiment are the same as those of the first embodiment.

First, a substrate 30 as the base for forming the carbon nanotube sheet 10 is prepared. As the substrate 30, a silicon substrate with an about 1 µm-thickness silicon oxide film formed on is used.

Next, a 2.5 nm-thickness Fe (iron) film is formed over the substrate 30 by, e.g., sputtering method to form a catalytic metal film 36 of Fe (FIG. 13A).

Next, over the substrate 30, a photoresist film 32 covering the regions for the carbon nanotube bundles 12 to be formed in and exposing the rest region is formed by photolithography.

Then, with the photoresist film 32 as the mask, the catalytic metal film 36 and the substrate 30 are anisotropically etched to form the concaves 38 of an about 500 nm-depth in the surface of the substrate 30 (FIG. 13B). The concaves 38 are formed in the regions other than the regions for the carbon nanotube bundles 12 to be formed on. The width of the concaves 38 can be set at, e.g., 20 µm, and the gap of the concaves 38 can be set at, e.g., 100 µm. Preferably, the width and the gap of the concaves 38 are set suitably in accordance with a thermal conductivity, etc. required for the carbon nanotube sheet 10.

Next, by, e.g., ashing, the photoresist film 32 is removed (FIG. 13C).

Then, with the catalytic metal film 36 as the catalyst, carbon nanotubes are grown by, e.g., hot filament CVD method. Thus, the carbon nanotube bundles 12 containing a plurality of the carbon nanotubes oriented in the direction of the normal of the substrate 30 are formed selectively on the regions of the substrate other than the regions for the concaves 38 to be formed in (FIG. 14A).

Then, by, e.g., spin coating, epoxy resin, for example, is applied, and then thermal processing, e.g., of 150 °C is made for 1 hour to harden the epoxy resin. Thus, the filling layer 14 of epoxy resin is formed. The filling layer 14 is formed also in the concaves 38 of the substrate 30 (FIG. 14B).

In FIG. 14B, the surfaces of the carbon nanotube bundles 12 and the surface of the filling layer 14 are flash with each other, but the ends of the carbon nanotube bundles 12 may be projected with respect to the surface of the filling layer 14. The process for forming such configuration is the same as in the first and the second embodiments.

Next, the carbon nanotube bundles 12 and the resin layer 14 are peeled from the substrate 30, and the carbon nanotube sheet 10 having the ends of the carbon nanotube bundles 12 positioned on one surface of the sheet lower than the surface of the filling layer 14 is obtained (FIG. 14C). As described above, according to the present embodiment, the carbon nanotube sheet comprising the carbon nanotube bundles having the ends recessed with respect to the surface of the filling layer can be easily formed. Thus, when the carbon nanotube sheet is press-contacted to an object for the carbon nanotube sheet to be mounted on, stresses exerted to the carbon nanotube bundles can be mitigated by the filling layer.

### [A Fourth Embodiment]

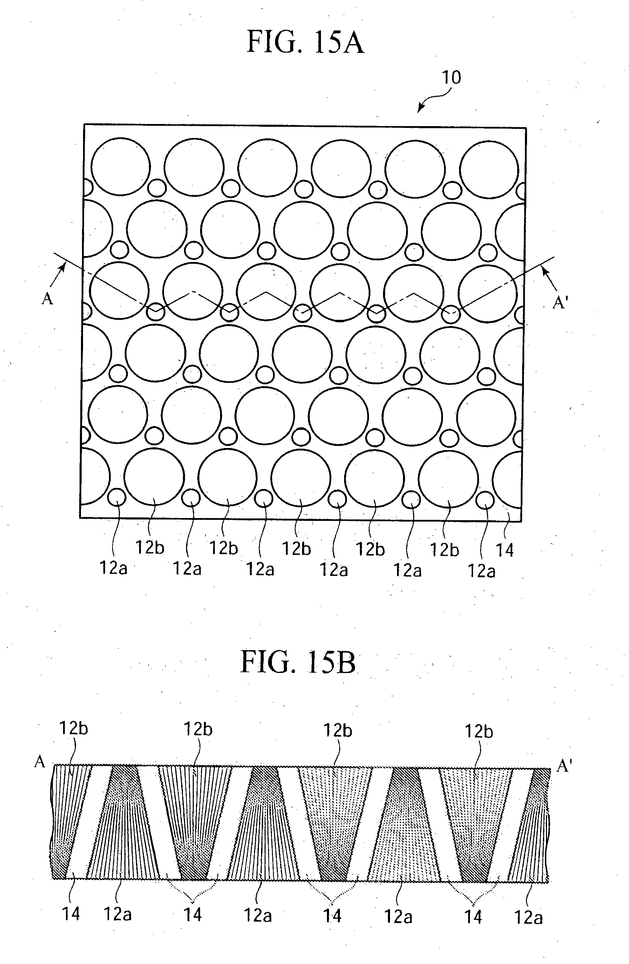

The carbon nanotube sheet and the method of manufacturing the same according to a fourth embodiment will be explained with reference to FIGs. 15A to 19B. The same members of the present embodiment as those of the carbon nanotube sheet and the method of manufacturing the same according to the first to the third embodiments illustrated in FIGs. 1A to 14C are represented by the same reference numbers not to repeat or to simplify their explanation.

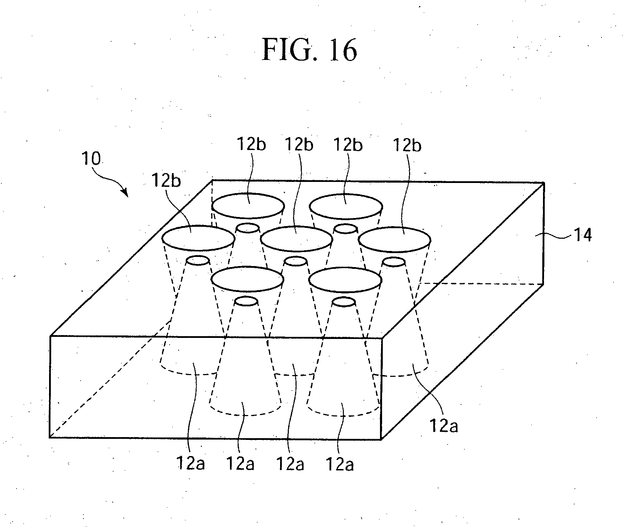

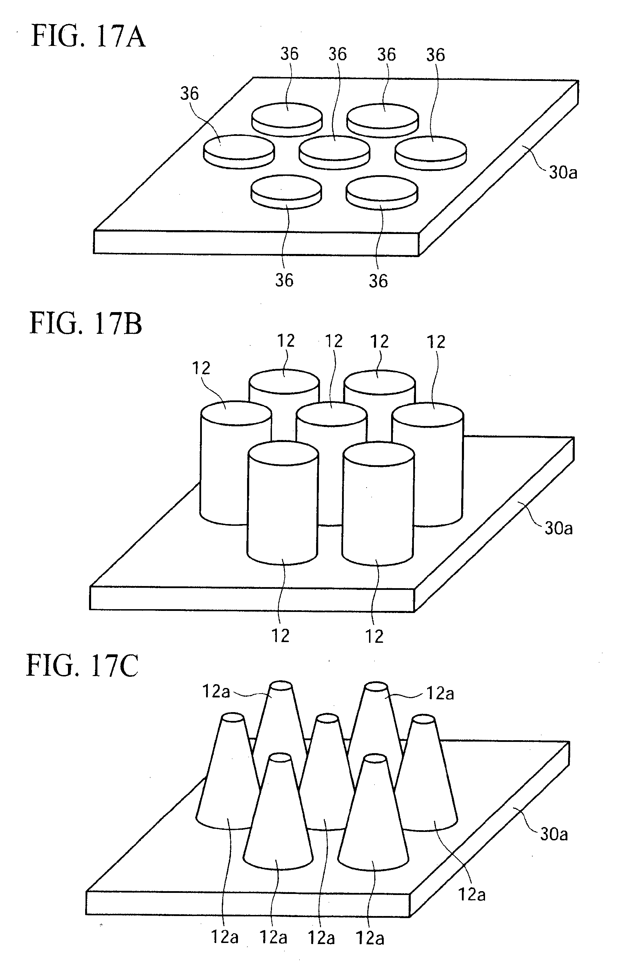

FIG. 15A is a plan view illustrating a structure of the carbon nanotube sheet according to the present embodiment. FIG. 15B is a diagrammatic sectional view illustrating the structure of the carbon nanotube sheet according to the present embodiment. FIG. 16 is a perspective view illustrating the structure of the carbon nanotube sheet according to the present embodiment. FIGs.17A-17C, 18A-18B and 19A-19B are views illustrating a method of manufacturing the carbon nanotube sheet according to the present embodiment.

First, the structure of the carbon nanotube sheet according to the present embodiment will be explained with reference to FIGs. 15A to 16.

As illustrated in FIGs. 15A to 16, the carbon nanotube sheet 10 according to the present embodiment is the same as the carbon nanotube sheet according to the first to the third embodiments in that a plurality of carbon nanotube bundles 12a, 12b are arranged spaced from each other with a gap, and a filling layer 14 of a resin material or others is filled in the gaps.

In the carbon nanotube sheet 10 according to the present embodiment, each of the plural carbon nanotube bundles 12 has a tapered configuration having the diameter of one end smaller than the diameter of the other end. Each of the carbon nanotube bundles 12a, 12b has the tapered configurations defined by the gaps between the carbon nanotubes gradually decreased from the end of the larger diameter toward the end of the smaller diameter. In other words, the number of the carbon nanotubes does not substantially change between the side of the larger diameter of the carbon nanotube bundles 12a, 12b and the side of the smaller diameter of the carbon nanotube bundles 12a, 12b.

The plurality of carbon nanotube bundles 12 are divided in the carbon nanotube bundles 12a having a smaller diameter on one surface of the carbon nanotube sheet 10, and the carbon nanotube bundles 12b having a smaller diameter on the other surface of the carbon nanotube sheet 10. As exemplified in FIGs. 15B and 16, the carbon nanotube bundles 12a and the carbon nanotube bundles 12b are arranged alternately so as to engage with each other and fill the gaps.

As the carbon nanotube sheet 10 is viewed from one surface of the carbon nanotube sheet 10, as exemplified in FIG. 15A and FIG. 15B, the smaller-diameter ends of the carbon nanotube bundles 12a and the large-diameter ends of the carbon nanotube bundles 12b are exposed. As illustrated in FIG. 15B, on the other surface of carbon nanotube sheet 10, the large-diameter ends of the carbon nanotube bundles 12a and the smaller-diameter ends of the carbon nanotube bundles 12b are exposed.

Such carbon nanotube bundles 12a, 12b are used to thereby increase the number of the carbon nanotubes per a unit area of the carbon nanotube sheet 10 (the surface density of the carbon nanotubes).

For example, when it is assumed that the diameters of the large-diameter ends of the carbon nanotube bundles 12b and the arrangement gap thereof are the same as those of the carbon nanotube bundles 12 of the carbon nanotube sheet according to the first embodiment illustrated in FIG. 1A, as illustrated in FIG. 15A, in the gaps between the carbon nanotube bundles 12b, the same number of the carbon nanotube bundles 12a can be further arranged. That is, the surface density of the carbon nanotubes of the carbon nanotube sheet 10 can be doubled. Thus, the thermal conductivity and electric conductivity of the carbon nanotube sheet 10 can be drastically increased.

Next, the method of manufacturing the carbon nanotube sheet according to the present embodiment will be explained with reference to FIGs 17A to 19B.

First, in the same way as in the method of manufacturing the carbon nanotube sheet according to, e.g., the first embodiment, a catalytic metal film 36 is formed on a substrate 30a in the regions for the carbon nanotube bundles 12 to be formed in (FIG. 17A). The substrate 30a is the same as the substrate 30 of the first to the third embodiments.

Next, over the substrate 30a, carbon nanotubes are grown with the catalytic metal film 36 as the catalyst by, e.g., hot filament CVD method. Thus, the carbon nanotube bundles 12 of a plurality of carbon nanotubes oriented in the normal direction of the substrate 30a are formed selectively over the substrate 30a in the regions where the catalytic metal film 36 has been formed (FIG. 17B).

Then, the substrate 30a with the carbon nanotube bundles 12 formed on is immersed in a liquid and dried. When the carbon nanotube bundles 12 are immersed in the liquid, the gaps between the carbon nanotubes are filled with the liquid. In this state, as the liquid goes on evaporating, with the decrease of the volume of the liquid between the carbon nanotubes, attractive forces work due to the surface tension between the adjacent carbon nanotubes. The ends of the carbon nanotube bundles 12, which are on the side of the substrate 30a are retained by the substrate 30a, and the gaps between the carbon nanotubes are not changed. However, with the forward ends of the carbon nanotubes being not secured, the gaps between the carbon nanotubes goes on gradually decreasing. When the gaps between the carbon nanotubes have sufficiently small, the carbon nanotubes are secured with the van der Waals force. Thus, the carbon nanotube bundle 12 after the liquid has been dried become the tapered nanotube bundles 12a having the diameter of the forward ends smaller than the diameter of the ends on the side of the substrate 30a (FIG. 17C).

The liquid to be used in tapering the carbon nanotube bundles 12 is not especially limited as long as the liquid has good wetting to the carbon nanotubes and is evaporable at a temperature which is not so high as to break the carbon nanotubes. For example, an organic chemical liquid, such as alcohol-based chemical liquid, ketone-based chemical liquid or others can be used. The alcohol-based chemical liquid is not especially limited and can be, e.g., isopropyl alcohol, ethanol, methanol, etc. The ketone-based chemical liquid is not especially limited and can be, e.g., acetone, methyl ethyl ketone, methyl isobutyl ketone, etc.

Then, in the same way as illustrated in FIGs. 17A to 17C, the tapered carbon nanotube bundles 12b are formed on a substrate 30b.

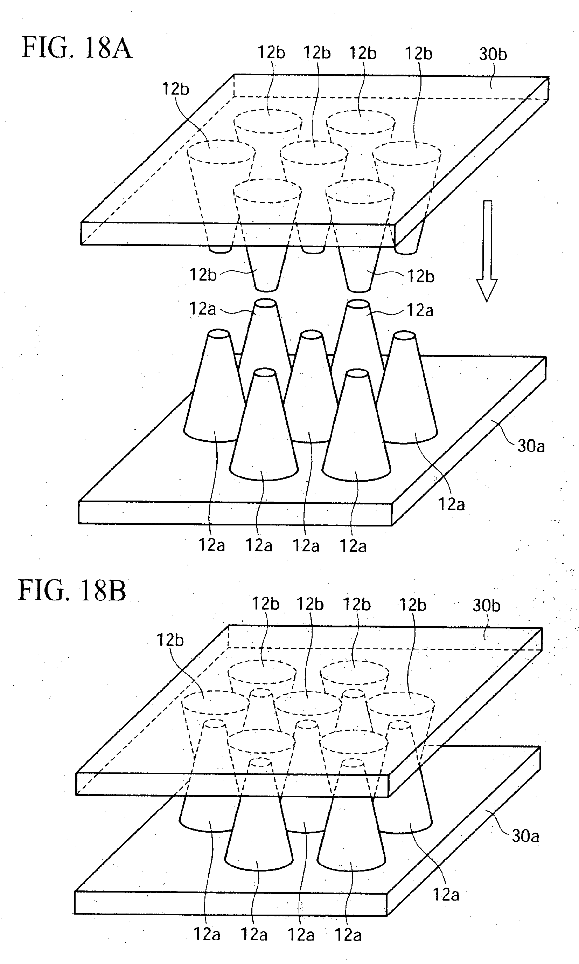

Next, the substrate 30a and the substrate 30b are bonded with each other with the surface of the substrate 30a, where the carbon nanotube bundles 12a are formed, and the surface of the substrate 30b, where the carbon nanotube bundles 12b are formed opposed to each other (FIGs. 18A and 18B).

At this time, the carbon nanotube bundles 12a, 12b are laid out alternately so as to engage with each other and fill the gaps, whereby the carbon nanotube bundles 12a fill the gaps between the carbon nanotube bundles 12b, and the carbon nanotube bundles 12b fill the gaps between the carbon nanotube bundles 12a. The forward ends of the carbon nanotube bundles 12a contacts the surface of the substrate 30b, and the forward ends of the carbon nanotube bundles 12b contact the surface of the substrate 30a.

The layout regions of the carbon nanotube bundles 12a, 12b are not limited to those of the present embodiment as long as the layout regions can mutually fill their gaps and can be suitably changed. The shape and the area of the regions for the carbon nanotube bundles 12a to be formed in and the shape and the area of the regions for the carbon nanotube bundles 12b to be formed in may be different from each other, and the layout of the carbon nanotube bundles 12a and that of the carbon nanotube bundles 12b may be different from each other.

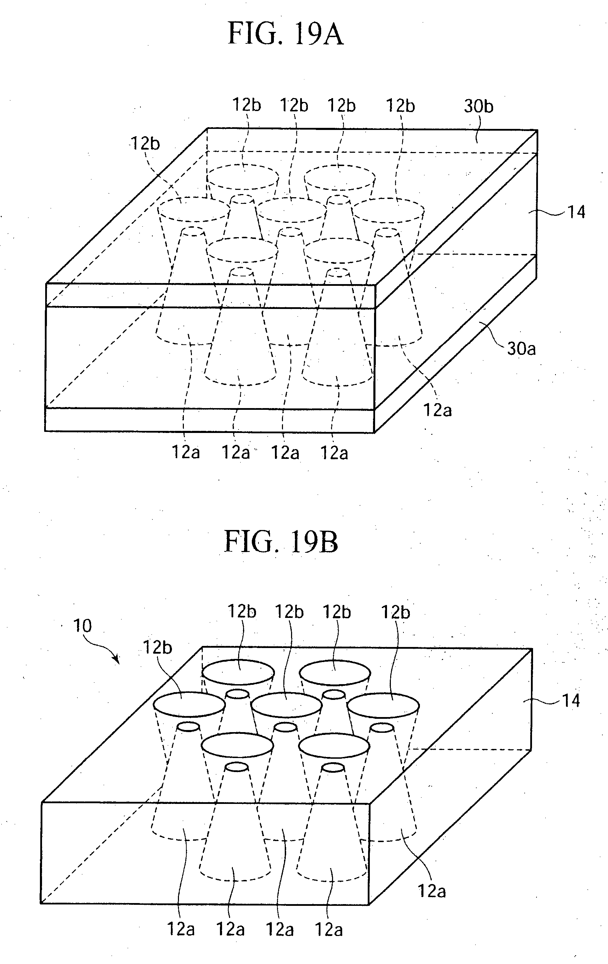

Then, a filling material to be the filling layer 14 is filled between the substrate 30a and the substrate 30b, and the filling layer 14 is filled between the carbon nanotube bundles 12a, 12b (FIG. 19A). At this time, the ends of the carbon nanotube bundles 12a, 12b, which are in direct contact with the substrates 30a, 30b, are not covered by the filling layer 14. The effect of preventing the cohesion of the carbon nanotubes is the same as in the first embodiment.

Then, in the same way as in the method of manufacturing the carbon nanotube sheet according to the first embodiment, the carbon nanotube bundles 12a, 12b, and the filling layer 14 are peeled from the substrates 30a. 30b, and the carbon nanotube sheet 10 is obtained (FIG. 19B).

Next, as required, the filling layer 14 is subjected to etching-back, etc. to project the ends of the carbon nanotube bundles 12a, 12b from the surface of the filling layer 14.

As described above, according to the present embodiment, the carbon nanotube sheet including the carbon nanotube bundles having a smaller diameter on one surface and the carbon nanotube bundles having a smaller diameter on the other surface is formed, whereby the surface density of the carbon nanotubes can be drastically increased. Thus, the thermal conductivity and/or the electrical conductivity of the carbon nanotube sheet can be drastically improved.

### [A Fifth Embodiment]

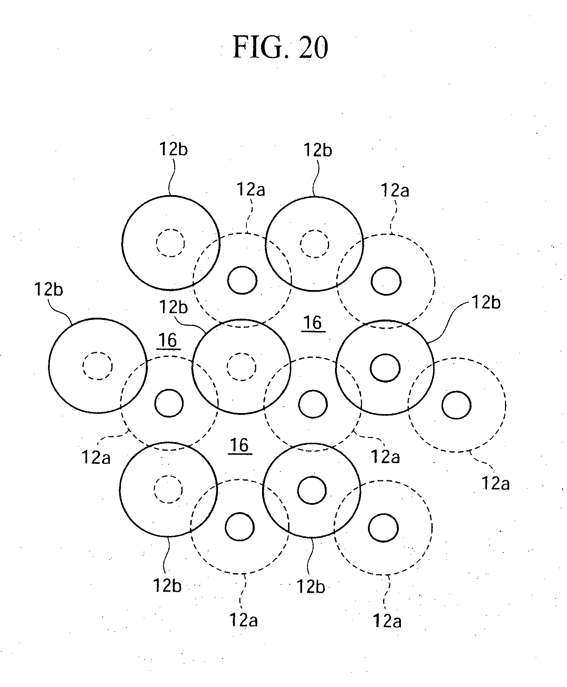

The carbon nanotube sheet and the method of manufacturing the same according to a fifth embodiment will be explained with reference to FIGs. 20 to 22B. The same members of the present embodiment as those of the carbon nanotube sheet and the method of manufacturing the same according to the first to the fourth embodiments illustrated in FIGs. 1A to 19B are represented by the same reference numbers not to repeat or to simplify their explanation.

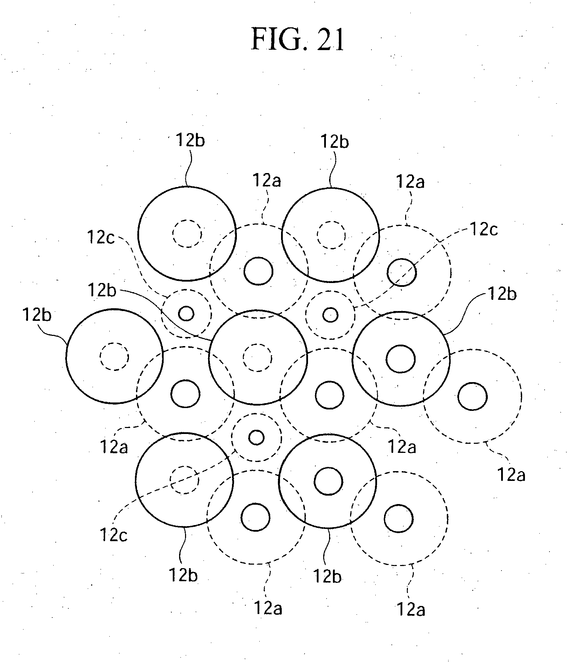

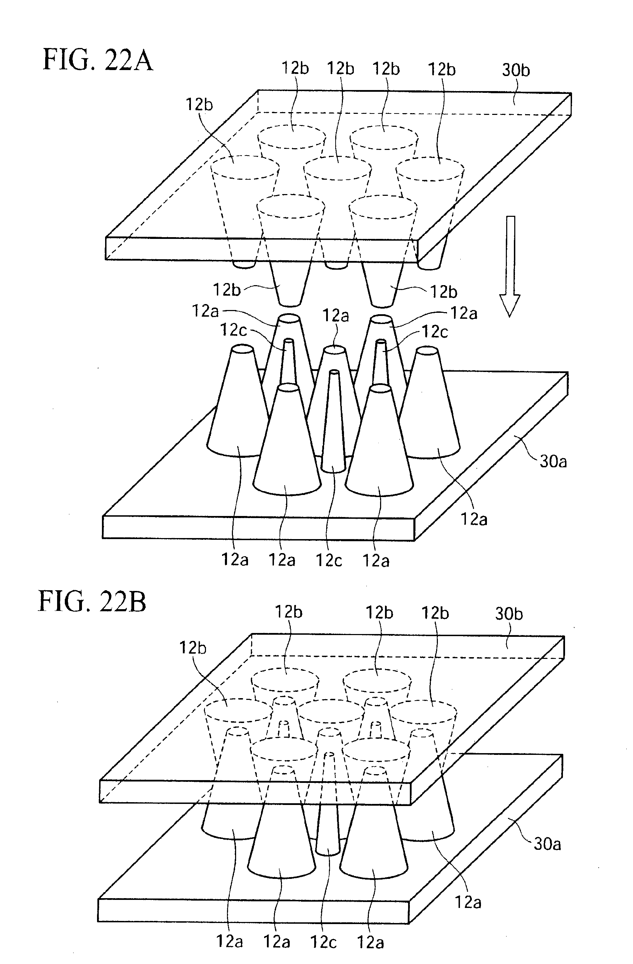

FIG. 20 is a plan view illustrating the structure of the carbon nanotube sheet according to the fourth embodiment. FIG. 21 is a plan view illustrating a structure of the carbon nanotube sheet according to the present embodiment. FIGs. 22A-22B are views illustrating the method of manufacturing the carbon nanotube sheet according to the present embodiment.

In the carbon nanotube sheet and the method of manufacturing the same according to the fourth embodiment, the two substrates 30a, 30b having the circular regions for the carbon nanotube bundles 12a, 12b formed in the close-packed type arrangement are bonded to each other to thereby improve the surface density of the carbon nanotubes. In this case, as illustrated in FIG. 20, the plane layout of the carbon nanotube bundles 12a, 12b after bonded has regions 16 where the carbon nanotube bundles 12a, 12b are not arranged. More carbon nanotube bundles are arranged in these regions 16, whereby the surface density of the carbon nanotubes can be further improved.

FIG. 21 illustrates the plane layout of the carbon nanotube bundles 12a, 12b and carbon nanotube bundles 12c arranged further in the regions 16 of the carbon nanotube sheet according to the present embodiment. The diameter of the carbon nanotube bundles corresponds to the areas of the regions 16 and is different from the diameters of the carbon nanotube bundles 12a, 12b.

Thus, the surplus gaps which cannot be filled by the carbon nanotube bundles 12a, 12b are filled by the carbon nanotube bundles 12c, whereby the surface density of the carbon nanotubes can be further improved, which leads to the improvement of the thermal conductivity and electric conductivity of the carbon nanotube sheet.

The carbon nanotube bundles 12c can be formed on the substrate side 30a concurrently with forming the carbon nanotube bundles 12a as exemplified in FIGs. 22A and 22B. Otherwise, all the carbon nanotube bundles 12c may be formed on the substrate 30b side, or the carbon nanotube bundles 12c may be formed on the substrate 30a side and the substrate 30b side.

The present embodiment is explained by means of the carbon nanotube sheet according to the fourth embodiment, in which the regions for the carbon nanotube bundles 12a, 12b to be formed in are close-packed type arrangement, but the layout the method according to the present embodiment is applicable to is not limited to this. When surplus gaps which cannot be filled by the carbon nanotube bundles 12a formed on the substrate 30a and the carbon nanotube bundles 12b formed on the substrate 30b are generated, the carbon nanotube bundles 12c may be additionally arranged so as to fill the gaps.

As described above, according to the present embodiment, the carbon nanotube bundles for filling surplus gaps are arranged in addition to the carbon nanotube bundles having a smaller diameter on the side of one surface and the carbon nanotube bundles having a smaller diameter on the side of the other surface, whereby the surface density of the carbon nanotubes can be further increased. Thus, the thermal conductivity and/or the electrical conductivity of the carbon nanotube sheet can be drastically improved.

### [A Sixth Embodiment]

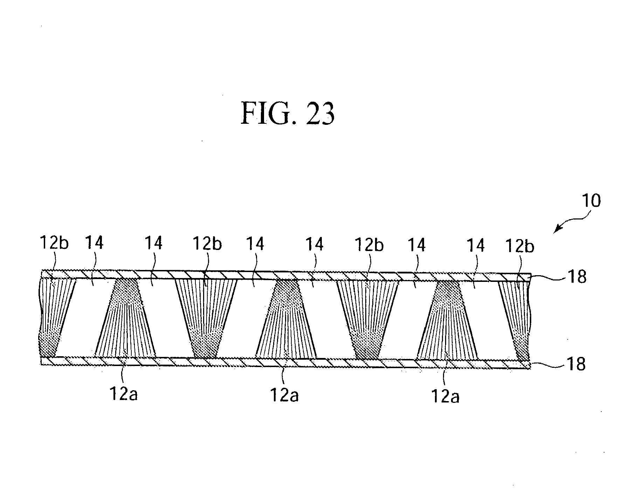

The carbon nanotube sheet and the method of manufacturing the same according to a sixth embodiment will be explained with reference to FIG. 23. The same members of the present embodiment as those of the carbon nanotube sheet and the method of manufacturing the same according to the first to the fifth embodiments illustrated in FIGs. 1A to 22B are represented by the same reference numbers not to repeat or to simplify their explanation.

FIG. 23 is a diagrammatic sectional view illustrating a structure of the carbon nanotube sheet according to the present embodiment.

The carbon nanotube sheet 10 according to the present embodiment is the same as the carbon nanotube sheet according to the fourth and the fifth embodiments in that the tapered carbon nanotube bundles 12a, 12b are formed in the filling layer 14. The carbon nanotube sheet 10 further includes coating film 18 on both surfaces thereof, connected to the ends of the carbon nanotube bundles 12a, 12b.

The coating film 18 provided on both surfaces of the sheet is not especially limited as long as the coating film 18 is formed of a material whose thermal conductivity is higher than that of the material forming the filling layer 14. When the carbon nanotube sheet 10 is used for electric conduction, a material having electric conductivity, e.g., a metal, an alloy or others can be used. As the constituent material of the coating film 18, copper (Cu), nickel (Ni), gold (Au) or others, can be used. The coating film 18 may not have essentially a single layer structure and may have a two-layer structure, or a three- or more-layer structure, e.g., the layer structure of titanium (Ti) and gold (Au).

The film thickness of the coating film 18 is not especially limited. Preferably, the film thickness of the coating film 18 is suitably decided, depending on characteristics required of the carbon nanotube sheet 10 and a constituent material of the coating film 18.

The coating film 18 of high thermal conductivity is provided, whereby the contact area of the carbon nanotube sheet 10 with respect to a mounted body (a radiator or a heater) can be increased with respect to the carbon nanotube sheet 10 without the coating film 18. Thus, the thermal contact resistance between the carbon nanotube bundles 12a, 12b and a mounted body is decreased, and the thermal conductivity of the carbon nanotube sheet 10 can be increased. In using the carbon nanotube sheet 10 as an electric conductive sheet, the electric conductivity can be increased.

The coating film 18 can be formed by, e.g., sputtering method after the step illustrated in FIG. 19B of the method of manufacturing the carbon nanotube sheet according to, e.g., the fourth embodiment. The coating film 18 of the layer film of, e.g., a 10 nm-thickness titanium (Ti) film and, e.g., a 50 nm-thickness gold (Au) film can be used.

As described above, according to the present embodiment, the coating film of a high thermal conductive material is formed on both surfaces of the sheet in contact with the ends of the carbon nanotube bundles, whereby the thermal contact resistance and the contact resistance between the sheet and a mounted body can be drastically decreased. Thus, the thermal conductivity and the electric conductivity of the carbon nanotube sheet can be improved.

### [A Seventh Embodiment]

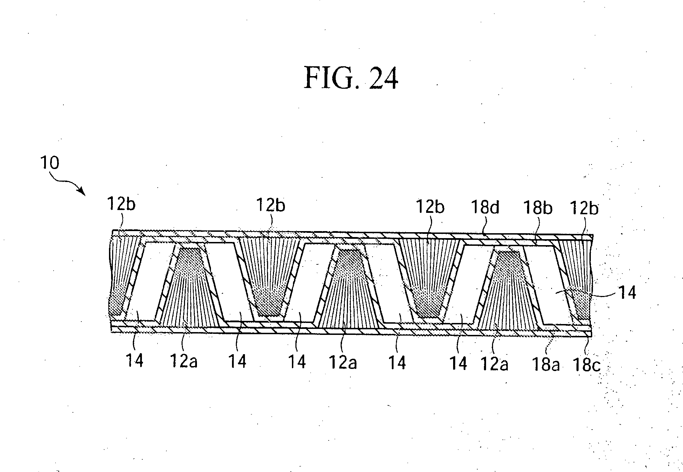

The carbon nanotube sheet and the method of manufacturing the same according to a seventh embodiment will be explained with reference to FIGs. 24 to 25D. The same members of the present embodiment as those of the carbon nanotube sheet and the method of manufacturing the same according to the first to the sixth embodiments illustrated in FIGs. 1A to 23 are represented by the same reference numbers not to repeat or to simplify their explanation.

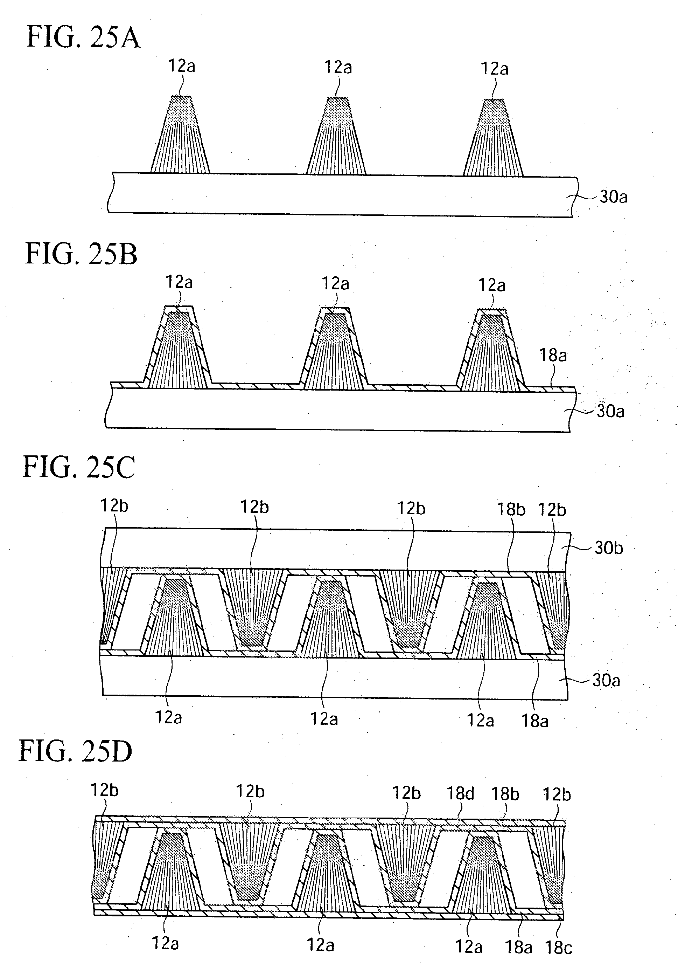

FIG. 24 is a diagrammatic sectional view illustrating a structure of the carbon nanotube sheet according to the present embodiment. FIGs. 25A-25D are views illustrating a method of manufacturing the carbon nanotube sheet according to the present embodiment.

First, the structure of the carbon nanotube sheet according to the present embodiment will be explained with reference to FIG. 24.

The carbon nanotube sheet 10 according to the present embodiment is the same as the carbon nanotube sheet according to the fourth and the fifth embodiments in that the tapered carbon nanotube bundles 12a, 12b are formed in the filling layer 14. The carbon nanotube sheet 10 according to the present embodiment further includes a coating film 18a formed along the surfaces of the carbon nanotube bundles 12a, a coating film 18b formed along the surfaces of the carbon nanotube bundles 12b, a coating film 18c formed entirely on one surface of the sheet and a coating film 18d formed entirely on the other surface of the sheet.

The coating films 18a, 18b, 18c, 18d are formed of a material whose thermal conductivity is higher than the constituent material of the filling layer 14, as is the coating film 18 of the sixth embodiment. When the carbon nanotube sheet 10 is used in electric conduction use, the coating films are formed of an electric conductive material.

The coating films 18a, 18b, 18c, 18d are provided, whereby the contact area of the carbon nanotube sheet 10 with respect to a mounted body can be increased in comparison with that of the carbon nanotube sheet 10 without the coating film 18. Thus, the thermal contact resistance between the carbon nanotube bundles 12a, 12b with the mounted body is decreased, ad the thermal conductivity of the carbon nanotube sheet 10 can be increased. When the carbon nanotube sheet 10 is used as the conductive sheet, the electric conductivity can be increased.

Next, the method of manufacturing the carbon nanotube sheet according to the present embodiment will be explained with reference to FIGs. 25A to 25D.

First, in the same way as in the method of manufacturing the carbon nanotube sheet according to, e.g., the fourth embodiment illustrated in FIGs. 17A to 17C, the tapered carbon nanotube bundles 12a are formed over the substrate 30a (FIG. 25A).

Next, a 10 nm-thickness titanium (Ti) film, for example, and a 50 nm-thickness gold (Au) film, for example, are deposited on the entire surface by, e.g., sputtering method to form the coating film 18a of the layer film of Au/Ti (FIG. 25B).

In the same way, over the substrate 30b, tapered carbon nanotube bundles 12b and the coating film 18b are formed.

Next, in the same way as in the method of manufacturing the carbon nanotube sheet according to, e.g., the fourth embodiment illustrated in FIGs. 18A and 18B, the substrate 30a and the substrate 30b are bonded to each other (FIG. 25C).

At this time, preferably, at least the surfaces of the coating films 18a, 18b are formed of a material which can be hot-press bonded to each other (e.g., gold). A pressure is applied to the substrate 30a and the substrate 30b while heating the substrates, whereby the coating films 18a, 18b can be hot-press bonded with each other at the upper ends of the carbon nanotube bundles 12a, 12b, and the connection between the coating films 18a, 18b can be ensured.

Then, the filling material to be the filling layer 14 is buried by potting method between the substrate 30a and the substrate 30b to thereby fill the filling layer 14 between the carbon nanotube bundles 12a, 12b. At this time, the ends of the carbon nanotube bundles 12a, 12b, which are in direct contact with the substrates 30a, 30b, are never coated with the filling layer 14. The effect of preventing the cohesion of the carbon nanotubes is the same as in the first embodiment.

Then, in the same way as in the method of manufacturing the carbon nanotube sheet according to, e.g., the first embodiment, the substrate 30a, 30b are peeled.

Next, in the same way as in the method of manufacturing the carbon nanotube sheet according to, e.g., the sixth embodiment, a 10 nm-thickness titanium (Ti) film, for example, and a 50 nm-thickness gold (Au) film, for example, are deposited on both surfaces of the sheet by, e.g., sputtering method. Thus, the coating films 18c, 18d of the layer film of Au/Ti are formed (FIG. 25D).

Thus, the carbon nanotube sheet 10 according to the present embodiment is completed.

As described above, according to the present embodiment, on both surfaces of the sheet, the coating films of a material of high thermal conductivity are formed in contact with the ends of the carbon nanotube bundles, whereby the thermal contact resistance and the electric contact resistance between the sheet and a mounted body can be drastically decreased. Thus, the thermal conductivity and electric conductivity of the carbon nanotube sheet can be improved.

### [An Eighth Embodiment]

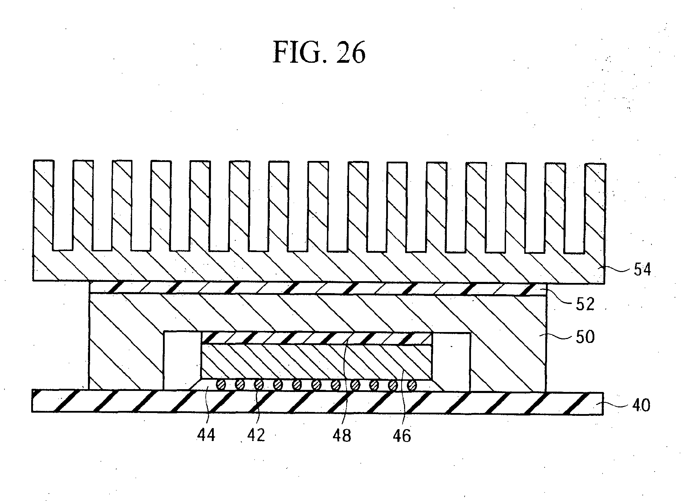

The electronic instrument according to a eighth embodiment will be explained with reference to FIG. 26.

FIG. 26 is a diagrammatic sectional view illustrating a structure of the electronic instrument according to the present embodiment.

In the present embodiment, an electronic instrument using the carbon nanotube sheet according to the first to the seventh embodiments as a thermal conductive sheet will be explained.

Over the circuit board 40 of, e.g., a multi-level interconnection substrate, a semiconductor element 46, such as a CPU, is mounted. The semiconductor element 46 is electrically connected to the circuit board 40, and an underfill 44 is filled between the circuit board 40 and the semiconductor element 46.

Over the semiconductor element 46, a heat spreader 50 for diffusing heat from the semiconductor element 46 is formed, covering the semiconductor element 46. Between the semiconductor element 46 and the heat spreader 50, the carbon nanotube sheet 48 is formed.

Over the heat spreader 50, a heat sink 54 for radiating heat conducted to the heat spreader is formed. Between the heat spreader 50 and the heat sink 54, the carbon nanotube sheet 52 is formed.

As described above, in the electronic instrument according to the present embodiment, the carbon nanotube sheets 48, 52 are disposed respectively between the semiconductor element 46 and the heat spreader 50 and between the heat spreader 50 and the heat sink 54.

As described in the first to the seventh embodiments, the disclosed carbon nanotube sheets have the carbon nanotube bundles 12 oriented vertically to the surface of the sheet, and has very high vertical thermal conductivity.

The disclosed carbon nanotube sheets are used as the thermal conductive sheets formed between the semiconductor element 46 and the heat spreader 50 and between the heat spreader 50 and the heat sink 54, whereby the heat generated by the semiconductor element 46 can be conducted effectively to the heat spreader 50 and the heat sink 54, and the heat radiating efficiency can be improved. Thus, the reliability of the electronic instrument can be improved.

As described above, according to the present embodiment, the carbon nanotube sheet comprising the carbon nanotube bundles oriented in the direction of thickness of the sheet is disposed between the semiconductor element and the heat spreader and between the heat spreader and heat sink, whereby the thermal conductivity between them can be large improved. Thus, the heat radiating efficiency of radiating the heat generated by the semiconductor element can be improved, and the reliability of the electronic instrument can be improved.

### [A Ninth Embodiment]

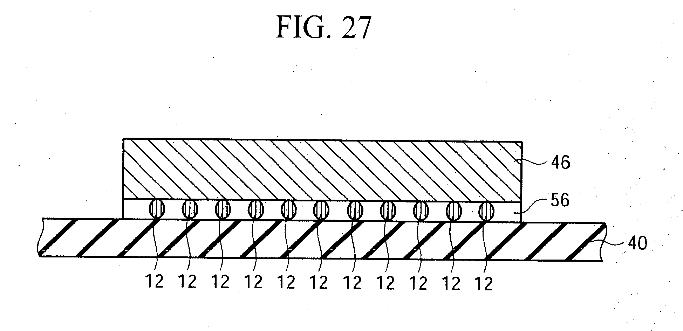

The electronic instrument according to a ninth embodiment will be explained with reference to FIG. 27.

FIG. 27 is a diagrammatic sectional view illustrating a structure of the electronic instrument according to the present embodiment.

In the present embodiment, an electronic instrument using the carbon nanotube sheet according to the first to the fifth embodiments as the vertical interconnecting sheet will be explained.

Over the circuit board 40 of, e.g., a multi-level interconnection substrate, a semiconductor element 46 of, e.g., a CPU is mounted. Between the circuit board 40 and the semiconductor element 46, the carbon nanotube sheet 56 is formed. The circuit board 40 and the semiconductor element 46 are electrically connected to each other via the carbon nanotube bundles 12 of the carbon nanotube sheet 56.

As described above, in the electronic instrument according to the present embodiment, the carbon nanotube sheet 56 is disposed between the circuit board 40 and the semiconductor element 46.

As described in the first to the seventh embodiments, the disclosed carbon nanotube sheets include the carbon nanotube bundles 12 oriented vertical to the film surface of the sheet and having the ends thereof exposed on both surfaces of the sheet. The carbon nanotube is also an electric conductor which is used as an interconnecting material.

Accordingly, the disclosed carbon nanotube sheets are used as the vertical interconnecting sheet formed between the circuit board 40 and the semiconductor element 46, whereby the circuit board 40 and the semiconductor device 46 can be electrically connected to each other.

As described above, according to the present embodiment, the disclosed carbon nanotube sheet having the carbon nanotube bundles oriented in the direction of film thickness of the sheet is disposed between the circuit board and the semiconductor element, whereby both can be electrically connected to each other.

### [A Tenth Embodiment]

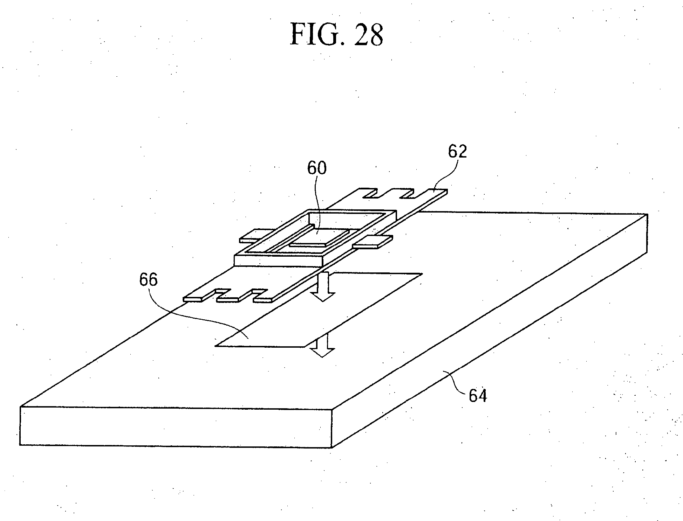

The electronic instrument according to a tenth embodiment will be explained with reference to FIG. 28.

FIG. 28 is a diagrammatic sectional view illustrating a structure of the electronic instrument according to the present embodiment.

In the present embodiment, an electronic instrument including the carbon nanotube sheet according to the first to the seventh embodiments used a thermal conductve sheet functioning also as an electrically conductive sheet will be explained.

As illustrated in FIG. 28, an HPA (High Power Amplifier) 60 used in radio communication stations is incorporated in a package 62 and is connected to a heat sink 64 on the underside of the package 62. Heat generated by the HPA 60 is radiated to the heat sink 64 through the underside of the package 62. Package 62 is also used as the electric ground and must be electrically connected to the heat sink 64. For the connection between the package 62 and the heat sink 64, it is preferable that a material having a good electric and thermal conductivity is used.

In the junction between the package 62 and the heat sink 64, as illustrated in FIG. 28, the carbon nanotube sheet 66 is used, whereby the package 62 and the heat sink 64 can be electrically connected to each other. Heat generated by the HPA 60 can be efficiently conducted to the heat sink 64, whereby the heat radiating efficiency can be increased. Thus, the reliability of the electronic instrument can be improved.

As described above, according to the present embodiment, the carbon nanotube sheet having the carbon nanotube bundles oriented in the direction of film thickness of the sheet is disposed between the package of the HPA and the heat sink, whereby the thermal conductivity between them can be largely increased. Thus, the thermal conductive efficiency of the heat generated by the HPA can be increased. Thus, the reliability of the electronic instrument can be improved. The HPA and the heat sink as the ground can be also electrically connected to each other.

### [Modified Embodiments]

The present invention is not limited to the above-described embodiments and can cover other various modifications.

For example, in the above-described amendments, as the examples of the sheet structure using the plurality of bundles of linear structures of carbon atoms, the carbon nanotube sheet using the plurality of carbon nanotube bundles are disclosed, but the sheet structure using the plurality of bundles of linear structures of carbon atoms is not limited to this. The linear structures of carbon atoms are applicable widely to the sheet structure. The linear structures of carbon atoms are, other than the carbon nanotubes, carbon nanowires, carbon rods, carbon fibers. These linear structures are different from the carbon nanotubes in size but are the same as the carbon nanotubes. These linear structures are also applicable to the sheet structure.

In the fourth to the seventh embodiments, two substrates with the tapered carbon nanotube bundles formed on are bonded to each other to form the carbon nanotube sheet, but it is not essentially necessary that the carbon nanotube bundles 12a, 12b are tapered. In these embodiments, the carbon nanotube bundles are tapered so as to improve the surface density of the carbon nanotube. When the sufficient properties can be obtained without tapering the carbon nanotube bundles, it is not essentially necessary that the carbon nanotube bundles 12a, 12b are tapered. It is not essentially necessary that the both of carbon nanotube bundles 12a, 12b are tapered. One of the carbon nanotube bundles 12a and the carbon nanotube bundles 12b may be tapered.

In the sixth and the seventh embodiments, the coating film having the thermal conductivity higher than the filling material is formed on the surfaces of the carbon nanotube sheet according to the fourth embodiment. The coating film may be also formed on the surfaces of the carbon nanotube sheets according to the first to the third embodiments.

The constituent material and the manufacturing conditions described in the above-described embodiments are not essential and can be changed suitably for purposes.

The uses of the carbon nanotube sheet described in the above embodiments are not essential. The disclosed carbon nanotube sheets are applicable, as the thermal conductive sheet, to, e.g., radiation sheets of CPUs, HPSs for radio communication stations, HPAs for radio communication terminals, high power switches for electric cars, servers, personal computers, etc. The high allowable current density of the carbon nanotube sheet can be utilized to be applied to the vertical interconnecting sheets and various applications using the vertical interconnecting sheets.

## Claims

1. A sheet structure (10) comprising:
a plurality of linear structure bundles (12a-12c) each of which comprises a plurality of linear structures of carbon atoms, the linear structures within each bundle being arranged so as to be spaced from each other at a first gap and the respective bundles being arranged so as to be spaced from each other at a second gap which is larger than the first gap, the plurality of linear structure bundles (12a, 12b) comprising those of a first group (12a) of bundles, each of which bundles is tapered with one end thereof on the same side of the structure as a first surface being smaller than the other end thereof on the same side of the structure as a second surface, and those of a second group (12b) of bundles, each of which bundles is tapered with one end thereof on the same side of the structure as the first surface being larger than the other end thereof on the same side of the structure as the second surface;
a filling layer (14) filling the second gap and supporting the plurality of linear structure bundles (12a-12c); **characterized in that**
a first coating film (18d) is formed over the first surface so as to be in contact with respective one ends of the plurality of linear structure bundles (12a-12c) and having a higher thermal conductivity than the filling layer (14); and
a second coating film (18c) is formed over the second surface so as to be in contact with respective other ends of the plurality of linear structure bundles (12a-12c) and having a higher thermal conductivity than the filling layer (14);
a third coating film (18a) is formed on surfaces of the linear structure bundles of the first group (12a) and having a higher thermal conductivity than the filling layer (14); and
a fourth coating film (18b) is formed on surfaces of the linear structure bundles of the second group (12b) and having a higher thermal conductivity than the filling layer (14).

2. The sheet structure according to claim 1, wherein
the linear structure bundles of the first group (12a) and the linear structure bundles of the second group (12b) are respectively arranged so as to engage with each other and fill gaps.

3. The sheet structure according to claim 2, wherein
the plurality of linear structure bundles (12a-12c) further comprises a third group (12c) of the linear structure bundles for filling surplus gaps which cannot be filled by the linear structure bundles contained in the first group (12a) and the linear structure bundles contained in the second group (12b).

4. The sheet structure according to any one of claims 1 to 3, wherein
each of the plurality of linear structures forming the plurality of linear structure bundles (12; 12a-12c) is oriented in a thickness direction of the filling layer (14).

5. An electronic instrument comprising a sheet structure as claimed in any preceding claim.

6. A method of manufacturing a sheet structure (10) comprising:
forming a catalytic metal film (36) in a plurality of regions (34) of a substrate (30), which regions (34) are spaced from each other;
forming a plurality of linear structure bundles (12) comprising a plurality of linear structures of carbon atoms in the respective plurality of regions (34) by growing liner structures of carbon atoms with the catalytic metal film (36) as a catalyst;
filling a filling material (14) between the linear structure bundles (12) and between the linear structures to form a filling layer (14) of the filling material;
removing the substrate (30);
forming over a first surface of the filling material (14) a first coating film (18; 18d), in contact with respective one ends of the plurality of linear structure bundles (12; 12a-12c) and having a higher thermal conductivity than the filling material (14); and
forming over a second surface of the filling material (14) a second coating film (18; 18c), in contact with respective other ends of the plurality of linear structure bundles (12; 12a-12c) and having a higher thermal conductivity than the filling material (14).

7. The method of manufacturing a sheet structure according to claim 6, wherein
in forming the filling layer (14), the filling material is applied by spin coating, and
a viscosity and/or a rotation number for applying the filling material are controlled so that the ends of the linear structure bundles (12) are exposed.

8. A method of manufacturing a sheet structure (10) comprising:
forming on a first substrate (30a) first linear structure bundles (12a) in respective plural regions spaced from each other;
forming on a second substrate (30b) second linear structure bundles (12b) in respective plural regions spaced from each other;
bonding the first substrate (30a) and the second substrate (30b) to each other with a surface of the first substrate (30a) with the first linear structure bundles (12a) formed thereon and a surface of the second substrate (30b) with the second linear structure bundles (12b) formed thereon opposed to each other to thereby engage the first linear structure bundles (12a) and the second linear structure bundles (12b) with each other and to fill gaps;
after bonding the first substrate (30a) and the second substrate (30b), filling a filling material (14) between the first linear structure bundles (12a) and the second linear structure bundles (12b) and between the linear structures to thereby form a filling layer (14);
removing the first substrate (30a) and the second substrate (30b);
forming over a first surface of the filling material (14) a first coating film (18d), in contact with respective one ends of the plurality of linear structure bundles (12a-12c) and having a higher thermal conductivity than the filling material (14); and
forming over a second surface of the filling material (14) a second coating film (18c), connected to respective other ends of the plurality of linear structure bundles (12a-12c) and having a higher thermal conductivity than the filling material (14).

9. The method of manufacturing a sheet structure according to claim 8, further comprising:
after forming the first linear structure bundles (12a), immersing the first linear structure bundles (12a) in a liquid and drying to thereby taper the first linear structure bundles (12a) in an upwardly decreasing manner; and
after forming the second linear structure bundles (12b), immersing the second linear structure bundles (12b) in a liquid and drying to thereby taper the second linear structure bundles (12b) in an upwardly decreasing manner.

10. The method of manufacturing a sheet structure according to claim 8, further comprising:
after forming the first linear structure bundles (12a), forming on the first substrate (30a) with the first linear structure bundles (12a) formed thereon a third coating film (18a) whose thermal conductivity is higher than the filling material (14); and
after forming second linear structure bundles (12b), forming on the second substrate (30b) with the second linear structure bundles (12b) formed thereon a fourth coating film (18b) whose thermal conductivity is higher than the filling material (14).

## Patentansprüche

1. Folienstruktur (10) mit: mehreren linearen Strukturbündeln (12a-12c), wobei jedes mehrere lineare Strukturen von Kohlenstoffatomen aufweist, wobei die linearen Strukturen innerhalb jedes Bündels derart angeordnet sind, dass sie voneinander um einen ersten Abstand beabstandet sind, und die entsprechenden Bündel derart angeordnet sind, dass sie voneinander um einen zweiten Abstand beabstandet sind, der größer als der erste Abstand ist, wobei die mehreren linearen Strukturbündel (12a, 12b) jene einer ersten Gruppe (12a) von Bündeln, von denen sich jedes Bündel verjüngt, wobei ein Ende davon auf der gleichen, eine erste Fläche darstellenden Seite der Struktur kleiner als das andere Ende davon auf der gleichen, eine zweite Fläche darstellenden Seite der Struktur ist, und jene einer zweiten Gruppe (12b) von Bündeln aufweisen, von denen sich jedes Bündel verjüngt, wobei ein Ende davon auf der gleichen, die erste Fläche darstellenden Seite der Struktur größer als das andere Ende davon auf der gleichen, die zweite Fläche darstellenden Seite der Struktur ist;
eine Füllschicht (14), die den zweiten Abstand füllt und die mehreren linearen Strukturbündel (12a-12c) abstützt;
**dadurch gekennzeichnet, dass**
ein erster Beschichtungsfilm (18d) derart über der ersten Fläche ausgebildet ist, dass er mit entsprechenden einen Enden der mehreren linearen Strukturbündel (12a-12c) in Kontakt ist, und eine höhere thermische Leitfähigkeit als die Füllschicht (14) aufweist; und
ein zweiter Beschichtungsfilm (18c) derart über der zweiten Fläche ausgebildet ist, dass er mit entsprechenden anderen Enden der mehreren linearen Strukturbündel (12a-12c) in Kontakt ist, und eine höhere thermische Leitfähigkeit als die Füllschicht (14) aufweist;
ein dritter Beschichtungsfilm (18a) auf Oberflächen der linearen Strukturbündel der ersten Gruppe (12a) ausgebildet ist, und eine höhere thermische Leitfähigkeit als die Füllschicht (14) aufweist; und
ein vierter Beschichtungsfilm (18b) auf Oberflächen der linearen Strukturbündel der zweiten Gruppe (12b) ausgebildet ist und eine höhere thermische Leitfähigkeit als die Füllschicht (14) aufweist.

2. Folienstruktur nach Anspruch 1, wobei
die linearen Strukturbündel der ersten Gruppe (12a) und die linearen Strukturbündel der zweiten Gruppe (12b) jeweils derart angeordnet sind, dass sie miteinander in Eingriff sind und Abstände füllen.

3. Folienstruktur nach Anspruch 2, wobei
die mehreren linearen Strukturbündel (12a-12c) ferner eine dritte Gruppe (12c) der linearen Strukturbündel zum Auffüllen übriger Abstände aufweisen, welche durch die in der ersten Gruppe (12a) enthaltenen linearen Strukturbündel und die in der zweiten Gruppe (12b) enthaltenen linearen Strukturbündel nicht gefüllt werden können.

4. Folienstruktur nach einem der Ansprüche 1 bis 3, wobei
jede der mehreren linearen Strukturen, welche die mehreren linearen Strukturbündel (12; 12a-12c) ausbilden, in einer Dicken-Richtung der Füllschicht (14) ausgerichtet ist.

5. Elektronische Vorrichtung mit einer Folienstruktur nach einem der vorhergehenden Ansprüche.

6. Verfahren zur Herstellung einer Folienstruktur (10) mit:
Ausbilden eines katalytischen Metallfilms (36) in mehreren Bereichen (34) eines Substrats (30), welche Bereiche (34) voneinander beabstandet sind;
Ausbilden mehrerer linearer Strukturbündel (12) mit mehreren linearen Strukturen von Kohlenstoffatomen in den entsprechenden mehreren Bereichen (34) durch Aufwachsen von Auskleidungsstrukturen aus Kohlenstoffatomen mit dem katalytischen Metallfilm (36) als ein Katalysator;
Füllen eines Füllmaterials (14) zwischen die linearen Strukturbündel (12) und zwischen die linearen Strukturen, um eine Füllschicht (14) des Füllmaterials auszubilden;
Entfernen des Substrats (30);
Ausbilden eines eine höhere thermische Leitfähigkeit als das Füllmaterial (14) aufweisenden ersten Beschichtungsfilms (18; 18d) über einer ersten Fläche des Füllmaterials (14) in Kontakt mit entsprechenden einen Enden der mehreren linearen Strukturbündel (12; 12a-12c); und
Ausbilden eines eine höhere thermische Leitfähigkeit als das Füllmaterial (14) aufweisenden zweiten Beschichtungsfilms (18; 18c) über einer zweiten Fläche des Füllmaterials (14) in Kontakt mit entsprechenden anderen Enden der mehreren linearen Strukturbündel (12; 12a-12c).

7. Verfahren zur Herstellung einer Folienstruktur nach Anspruch 6, wobei
beim Ausbilden der Füllschicht (14) das Füllmaterial durch Spin-Coating appliziert wird, und
eine Viskosität und/oder eine Drehzahl zum Applizieren des Füllmaterials derart reguliert werden, dass die Enden der linearen Strukturbündel (12) freigelegt sind.

8. Verfahren zur Herstellung einer Folienstruktur (10) mit:
Ausbilden von ersten linearen Strukturbündeln (12a) auf einem ersten Substrat (30a) in entsprechenden mehreren voneinander beabstandeten Bereichen;
Ausbilden von zweiten linearen Strukturbündeln (12b) auf einem zweiten Substrat (30b) in entsprechenden mehreren voneinander beabstandeten Bereichen;
Anbinden des ersten Substrats (30a) und des zweiten Substrats (30b) aneinander, wobei eine Fläche des ersten Substrats (30a) mit den darauf ausgebildeten ersten linearen Strukturbündeln (12a) und eine Fläche des zweiten Substrats (30b) mit den darauf ausgebildeten zweiten linearen Strukturbündeln (12b) einander gegenüberliegen, um dadurch die ersten linearen Strukturbündel (12a) und die zweiten linearen Strukturbündel (12b) miteinander in Eingriff zu bringen und um Abstände füllen;
Füllen eines Füllmaterials (14) zwischen die ersten linearen Strukturbündel (12a) und die zweiten linearen Strukturbündel (12b) und zwischen die linearen Strukturen nach dem Verbinden des ersten Substrats (30a) und des zweiten Substrats (30b), um dadurch eine Füllschicht (14) auszubilden;
Entfernen des ersten Substrats (30a) und des zweiten Substrats (30b);
Ausbilden eines eine höhere thermische Leitfähigkeit als das Füllmaterial (14) aufweisenden ersten Beschichtungsfilms (18d) über einer ersten Fläche des Füllmaterials (14) in Kontakt mit entsprechenden einen Enden der mehreren linearen Strukturbündel (12a-12c); und
Ausbilden eines eine höhere thermische Leitfähigkeit als das Füllmaterial (14) aufweisenden zweiten Beschichtungsfilms (18c) über einer zweiten Fläche des Füllmaterials (14), der mit den entsprechenden anderen Enden der mehreren linearen Strukturbündel (12a-12c) verbunden ist.

9. Verfahren zur Herstellung einer Folienstruktur nach Anspruch 8, ferner mit:
Tränken der ersten linearen Strukturbündel (12a) in einer Flüssigkeit und Trocknen nach dem Ausbilden der ersten linearen Strukturbündel (12a), um dadurch die ersten linearen Strukturbündel (12a) in eine nach oben abnehmende Weise zu verjüngen; und
Tränken der zweiten linearen Strukturbündel (12b) in einer Flüssigkeit und Trocknen nach dem Ausbilden der zweiten linearen Strukturbündel (12b), um dadurch die zweiten linearen Strukturbündel (12b) in eine nach oben abnehmende Weise zu verjüngen.

10. Verfahren zur Herstellung einer Folienstruktur nach Anspruch 8, ferner mit:
Ausbilden eines dritten Beschichtungsfilms (18a), dessen thermische Leitfähigkeit höher als die des Füllmaterials (14) ist, auf dem ersten Substrat (30a) mit den darauf ausgebildeten ersten linearen Strukturbündeln (12a), nach dem Ausbilden der ersten linearen Strukturbündel (12a); und
Ausbilden eines vierten Beschichtungsfilms (18b), dessen thermische Leitfähigkeit höher als die des Füllmaterials (14) ist, auf dem zweiten Substrat (30b) mit den darauf ausgebildeten zweiten linearen Strukturbündeln (12b) nach dem Ausbilden der zweiten linearen Strukturbündel (12b).

## Revendications

1. Structure de feuille (10) qui comprend :
une pluralité d'ensembles de structures linéaires (12a-12c) qui comprennent chacun une pluralité de structures linéaires d'atomes de carbone, les structures linéaires de chaque ensemble étant disposées de façon à être espacées les unes des autres selon une première distance, et les ensembles respectifs étant disposés de façon à être espacés les uns des autres selon une seconde distance qui est supérieure à la première distance, la pluralité d'ensembles de structures linéaires (12a, 12b) comprenant celles d'un premier groupe (12a) d'ensembles, qui sont chacun effilés avec une extrémité du même côté de la structure qui fait office de première surface plus petite que l'autre extrémité du même côté de la structure qui fait office de seconde surface, et celles d'un second groupe (12b) d'ensembles, qui sont chacun effilés avec une extrémité du même côté de la structure qui fait office de première surface plus grande que l'autre extrémité du même côté de la structure qui fait office de seconde surface ;
une couche de remplissage (14) qui remplit le second espace et qui supporte la pluralité d'ensembles de structures linéaires (12a-12c) ; **caractérisée en ce que**
un premier film de revêtement (18d) est formé par-dessus la première surface de façon à être en contact avec des extrémités respectives de la pluralité d'ensembles de structures linéaires (12a-12c) et possède une conductivité thermique supérieure à celle de la couche de remplissage (14) ; et
un second film de revêtement (18c) est formé par-dessus la seconde surface de façon à être en contact avec les autres extrémités respectives de la pluralité d'ensembles de structures linéaires (12a-12c) et possède une conductivité thermique supérieure à celle de la couche de remplissage (14) ;
un troisième film de revêtement (18a) est formé sur les surfaces des ensembles de structures linéaires du premier groupe (12a) et possède une conductivité thermique supérieure à celle de la couche de remplissage (14) ; et
un quatrième film de revêtement (18b) est formé sur les surfaces des ensembles de structures linéaires du second groupe (12b) et possède une conductivité thermique supérieure à celle de la couche de remplissage (14).

2. Structure de feuille selon la revendication 1, dans laquelle
les ensembles de structures linéaires du premier groupe (12a) et les ensembles de structures linéaires du second groupe (12b) sont respectivement disposés de façon à s'engager les uns avec les autres et à remplir les espaces.

3. Structure de feuille selon la revendication 2, dans laquelle
la pluralité d'ensembles de structures linéaires (12a-12c) comprend en outre un troisième groupe (12c) d'ensembles de structures linéaires destiné à remplir les espaces en trop qui ne peuvent pas être remplis par les ensembles de structures linéaires contenus dans le premier groupe (12a) et les ensembles de structures linéaires contenus dans le second groupe (12b).

4. Structure de feuille selon l'une quelconque des revendications 1 à 3, dans laquelle
chacune de la pluralité de structures linéaires qui forment la pluralité d'ensembles de faisceaux linéaires (12 ; 12a-12c) est orientée dans une direction d'épaisseur de la couche de remplissage (14).

5. Instrument électronique qui comprend une structure de feuille selon l'une quelconque des revendications précédentes.

6. Procédé de fabrication d'une structure de feuille (10) qui comprend :
la formation d'un métal de métal catalytique (36) dans une pluralité de zones (34) d'un substrat (30), lesdites zones (34) étant espacées les unes des autres ;
la formation d'une pluralité d'ensembles de structures linéaires (12) qui comprennent une pluralité de structures linéaires d'atomes de carbone dans la pluralité respective de zones (34) en développant des structures linéaires d'atomes de carbone avec le film de métal catalytique (36) en guise de catalyseur ;
le placement d'un matériau de remplissage (14) entre les ensembles de structures linéaires (12) et entre les structures linéaires afin de former une couche de remplissage (14) en matériau de remplissage ;
le retrait du substrat (30) ;
la formation, par-dessus une première surface du matériau de remplissage (14), d'un premier film de revêtement (18 ; 18d), en contact avec des extrémités respectives de la pluralité d'ensembles de structures linéaires (12 ; 12a-12c) et qui possède une conductivité thermique supérieure à celle du matériau de remplissage (14) ; et
la formation, par-dessus une seconde surface du matériau de remplissage (14), d'un second film de revêtement (18 ; 18c), en contact avec les autres extrémités respectives de la pluralité d'ensembles de structures linéaires (12, 12a-12c) et qui possède une conductivité thermique supérieure à celle du matériau de remplissage (14).

7. Procédé de fabrication d'une structure de feuille selon la revendication 6, dans laquelle
lors de la formation de la couche de remplissage (14), le matériau de remplissage est appliqué par dépôt par rotation, et
une viscosité et/ou un nombre de rotations pour l'application du matériau de remplissage est contrôlé(e) de sorte que les extrémités des ensembles de structures linéaires (12) soient exposées.

8. Procédé de fabrication d'une structure de feuille (10) qui comprend :
la formation, sur un premier substrat (30a), de premiers ensembles de structures linéaires (12a) dans plusieurs zones respectives espacées les unes des autres ;
la formation, sur un second substrat (30b), de seconds ensembles de structures linéaires (12b) dans plusieurs zones respectives espacées les unes des autres ;
la liaison du premier substrat (30a) au second substrat (30b), avec une surface du premier substrat (30a) qui présente les premiers ensembles de structures linéaires (12a) formés dessus et une surface du second substrat (30b) qui présente les seconds ensembles de structures linéaires (12b) formés dessus opposées l'une à l'autre afin d'engager les premiers ensembles de structures linéaires (12a) et les seconds ensembles de structures linéaires (12b) les uns avec les autres, et de remplir les espaces ;
après la liaison du premier substrat (30a) et du second substrat (30b), le placement d'un matériau de remplissage (14) entre les premiers ensembles de structures linéaires (12a) et les seconds ensembles de structures linéaires (12b), et entre les structures linéaires, afin de former une couche de remplissage (14) ;
le retrait du premier substrat (30a) et du second substrat (30b) ;
la formation, par-dessus une première surface du matériau de remplissage (14), d'un premier film de revêtement (18d), en contact avec des extrémités respectives de la pluralité d'ensembles de structures linéaires (12a-12c), et qui possède une conductivité thermique supérieure à celle du matériau de remplissage (14) ; et
la formation, par-dessus une seconde surface du matériau de remplissage (14), d'un second film de revêtement (18c), relié aux autres extrémités respectives de la pluralité d'ensembles de structures linéaires (12a-12c), et qui possède une conductivité thermique supérieure à celle du matériau de remplissage (14).

9. Procédé de fabrication d'une structure de feuille selon la revendication 8, qui comprend en outre :
après la formation des premiers ensembles de structures linéaires (12a), l'immersion des premiers ensembles de structures linéaires (12a) dans un liquide, et leur séchage de façon à effiler les premiers ensembles de structures linéaires (12a) vers le haut ;
et
après la formation des seconds ensembles de structures linéaires (12b), l'immersion des seconds ensembles de structures linéaires (12b) dans un liquide, et leur séchage de façon à effiler les seconds ensembles de structures linéaires (12b) vers le bas.

10. Procédé de fabrication d'une structure de feuille selon la revendication 8, qui comprend en outre :
après la formation des premiers ensembles de structures linéaires (12a), la formation, sur le premier substrat (30a) qui présente les premiers ensembles de structures linéaires (12a) formés dessus, d'un troisième film de revêtement (18a) dont la conductivité thermique est supérieure à celle du matériau de remplissage (14) ; et
après la formation des seconds ensembles de structures linéaires (12b), la formation, sur le second substrat (30b) qui présente les seconds ensembles de structures linéaires (12b) formés dessus, d'un quatrième film de revêtement (18b) dont la conductivité thermique est supérieure à celle du matériau de remplissage (14).
